# EUROPÄISCHE PATENTSCHRIFT

(11) **EP 4 146 479 B1**
(45) Veröffentlichungstag und Bekanntmachung des Hinweises auf die Patenterteilung: **31.07.2024**
(21) Anmeldenummer: 21732180.1
(22) Anmeldetag: 06.04.2021
(51) Int. Cl.: B41F 23/04, B41J 11/00, F26B 3/28

(54) **VORRICHTUNG ZUR BESTRAHLUNG EINES SUBSTRATES**
APPARATUS FOR IRRADIATING A SUBSTRATE
APPAREIL D'IRRADIATION D'UN SUBSTRAT

(30) Priorität: 08.05.2020 DE 202020002017 U
(43) Veröffentlichungstag der Anmeldung: 15.03.2023
(73) Patentinhaber: Ackermann, Gunther, 83059 Kolbermoor (DE)
(72) Erfinder: ACKERMANN, Gunter, 83059 Kolbermoor (DE)
(74) Vertreter: Nowack, Linda
(86) Internationale Anmeldenummer: PCT/DE2021/000062
(87) Internationale Veröffentlichungsnummer: WO 2021/223787

(56) Entgegenhaltungen:
- DE-A1- 102010 046 756
- DE-A1- 102017 011 881
- DE-A1- 102017 129 017

## Beschreibung

Die vorliegende Erfindung betrifft eine Vorrichtung zur Bestrahlung eines Substrates, mit den in dem Patentanspruch 1 angegebenen Merkmalen.

Aus der DE 10 2017 129017 A1 geht ein Infrarot-Trocknermodul zum Trocknen eines in einer Substratebene und in einer Transportrichtung durch einen Prozessraum bewegten Substrats hervor, umfassend eine Strahlereinheit, eine Prozessgas-Zuführungseinheit und eine Ablufteinheit.

Aus der DE 102 34 076 A1 geht eine Flachdruckmaschine für den 4-Farben-Offset-Druck hervor, bei der Strahlungsenergie des nahen Infrarot-Wellenlängenbereiches einem Bedruckstoff zugeführt wird, wobei der Druckfarbe ein Infrarot-Absorberstoff zugesetzt wird. Die Strahlung wird dort von nebeneinander und hintereinander reihenweise angeordneten Einzel-Strahlern erzeugt.

Diese aus der DE 102 34 076 A1 bekannte Bestrahlungsvorrichtung ist insbesondere deswegen nachteilig, weil in dem Falle einer Störung der - von der Rückseite her nicht erkennbare - defekte Strahler zunächst mühsam ermittelt, zeitintensiv ausgebaut, repariert, wieder eingesetzt und in Bezug auf seine Ausrichtung dann - Fehlermöglichkeiten einschließend - justiert werden muss.

Die Aufgabe der vorliegenden Erfindung besteht daher in der Bereitstellung einer Vorrichtung zur Bestrahlung von Substraten, welche - in dem Falle einer Störung einer oder von mehreren Bestrahlungseinrichtungen - eine besonders einfache, schnelle, mühelose und Fehlermöglichkeiten ausschließende Reparatur gestattet.

Erfindungsgemäß wird diese Aufgabe durch eine Vorrichtung zur Bestrahlung eines Substrates, mit den in dem Patentanspruch 1 angegebenen Merkmalen gelöst. Besonders bevorzugte Ausführungsformen der erfindungsgemäßen Vorrichtung sind Gegenstand der Unteransprüche.

Besonders bevorzugte Ausführungsformen der erfindungsgemäßen Vorrichtung werden anhand der Zeichnungen näher beschrieben. Es zeigen:

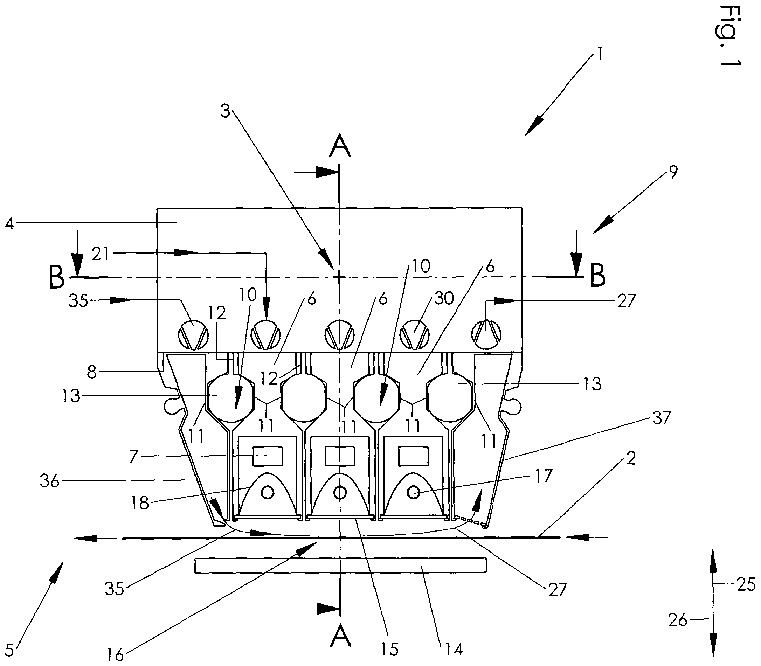

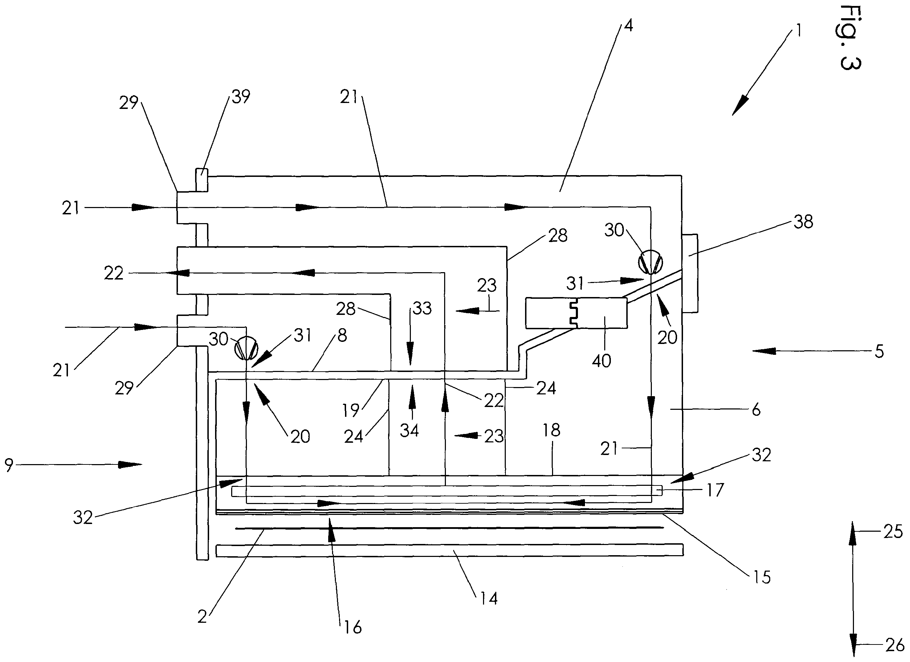

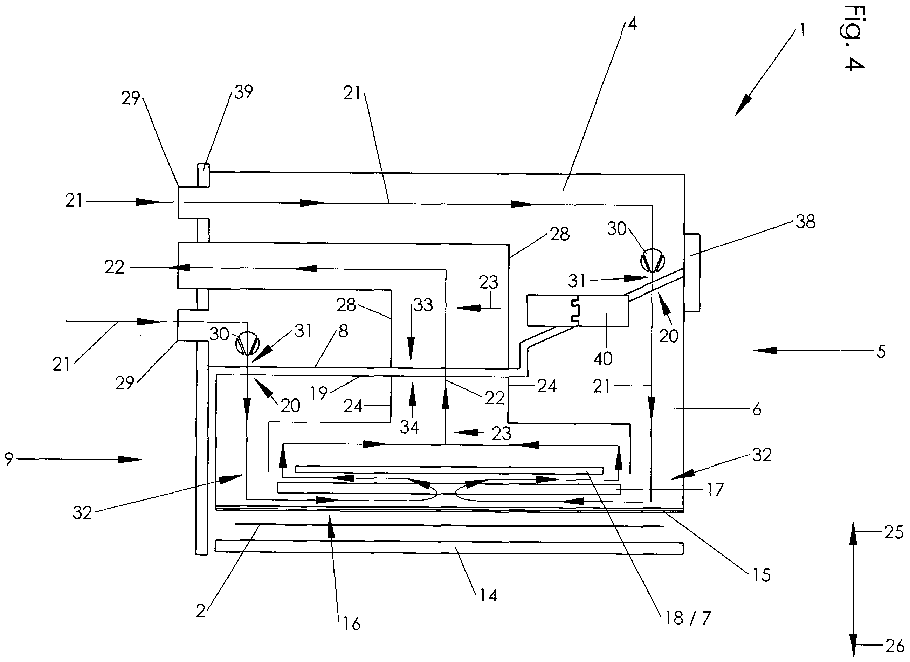

Figur 1 eine schematische Vorderansicht (5) einer Vorrichtung (1) zur Bestrahlung eines Substrates (2), welche eine oben-(25)-liegende, - in Bezug auf die Längsachse (3) der Plattform (4) gerade - Plattform (4) umfasst, wobei an der Unterseite (8) der Plattform (4) drei Modul-Anbringungs-Einrichtungen (10) für ein - von der Vorderseite (5) der Vorrichtung (1) ausgehendes und sich in Richtung der Rückseite (9) der Vorrichtung (1) erstreckendes - frontales Einschieben von drei Bestrahlungsmodulen (6) vorgesehen sind, wobei einerseits der drei Bestrahlungsmodule (6) ein Substrat-Zuluft-Modul (36) und andererseits der drei Bestrahlungsmodule (6) ein Substrat-Abluft-Modul (37) vorgesehen ist, um eine das zu bestrahlende Substrat (2) überstreichende Luft-Strömung zu generieren, wobei in jedes Bestrahlungsmodul (6) noch nicht erwärmtes, frisches, gasförmiges oder flüssiges Bestrahlungsmodul-Kühlmedium (21) zur Kühlung des Leuchtmittels (17) des Bestrahlungsmodules (6) und dessen Reflektors (18) mit seinen Kühlrippen (7) zuführbar ist, wobei das - erst in den Figuren 3 und 4 dargestellte - von dem Leuchtmittel (17) erwärmte Bestrahlungsmodul-Kühlmedium (22) über eine - ebenfalls erst in den Figuren 3 und 4 dargestellte - Führung (24) aus dem Bestrahlungsmodul (6) - mittelbar über die mittige Führung (28) der Plattform (4) in Richtung der obenliegenden (25) Plattform (4) - und nach außen abführbar ist;

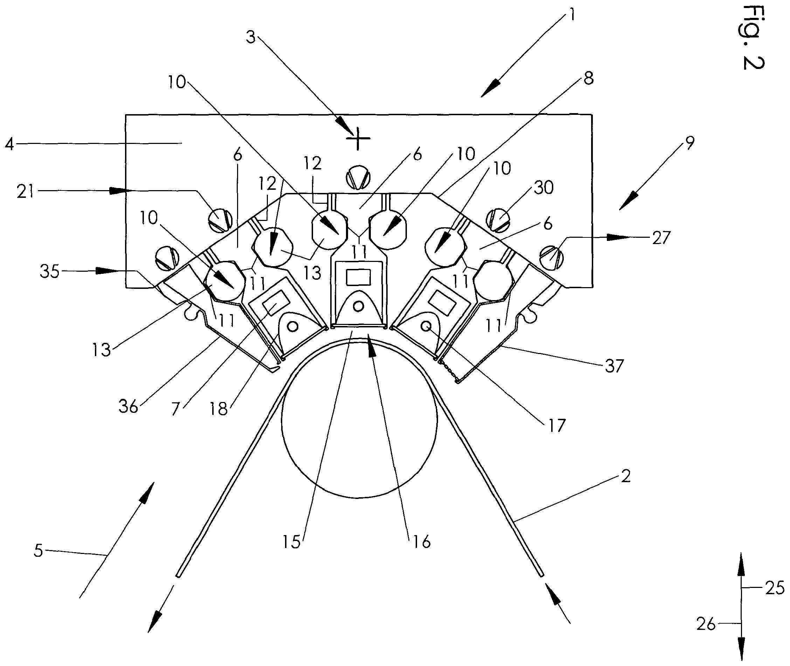

Figur 2 eine schematische Vorderansicht (5) einer Vorrichtung (1) zur Bestrahlung eines Substrates (2), welche eine oben (25)-liegende, um die Längsachse (3) der Plattform (4) gekrümmte Plattform (4) umfasst, wobei an der Unterseite der gekrümmten Plattform (4) drei Modul-Anbringungs-Einrichtungen (10) für ein - von der Vorderseite (5) der Vorrichtung (1) ausgehendes und sich in Richtung der Rückseite (9) der Vorrichtung (1) erstreckendes - frontales Einschieben von drei Bestrahlungsmodulen (6) vorgesehen sind, wobei einerseits der drei Bestrahlungs-module (6) ein Substrat-Zuluft-Modul (36) und andererseits der drei Bestrahlungsmodule (6) ein Substrat-Abluft-Modul (37) vorgesehen ist, um eine das zu bestrahlende Substrat (2) überstreichende Luftströmung (35) zu generieren, wobei in jedes Bestrahlungsmodul (6) noch nicht erwärmtes, frisches, gasförmiges oder flüssiges Bestrahlungsmodul-Kühlmedium (21) zur Kühlung des Leuchtmittels (17) des Bestrahlungsmodules (6) und dessen Reflektors (18) mit seinen Kühlrippen (7) zuführbar ist, wobei das - erst in den Figuren 3 und 4 dargestellte - von dem Leuchtmittel (17) erwärmte Bestrahlungsmodul-Kühlmedium (22) über eine - ebenfalls erst in den Figuren 3 und 4 dargestellte - Führung (24) aus dem Bestrahlungsmodul (6) - mittelbar über die mittige Führung (28) der Plattform (4) in Richtung der obenliegenden (25) Plattform (4) - und nach außen abführbar ist;
Figur 3 einen schematischen Schnitt entlang der in Figur 1 dargestellten Linie A-A, welcher eine obenliegende (25) Plattform (4) und ein - zu der Unterseite (8) der Plattform (4) korrespondierend ausgebildetes - Bestrahlungsmodul (6) zeigt, wobei in die Plattform (4) zwei Leitungen (29) für das noch nicht erwärmte, frische gasförmige oder flüssige Bestrahlungsmodul-Kühlmedium (21) von außen her einmünden, wobei in diese Leitungen (29) - innerhalb der Plattform (4) - jeweils ein Gebläse (30) oder eine Pumpe integrierbar ist, welches das Bestrahlungsmodul-Kühlmedium (21) in Richtung von zwei Bestrahlungsmodul-Kühlmedium-Austrittsöffnungen (31) der Plattform (4) beschleunigt oder komprimiert, wobei die beiden Bestrahlungsmodul-Kühlmedium-Austrittsöffnungen (31) jeweils auf der Unterseite (8) der Plattform (4) - und zum einen in dem Bereich der Rückseite (9) der Vorrichtung (1) und zum anderen in dem Bereich der Vorderseite (5) der Vorrichtung (1) - vorgesehen sind, wobei auf der Oberseite (19) des Bestrahlungsmodules (6) zwei Bestrahlungsmodul-Kühlmedium-Eintrittsöffnungen (20) für die Zufuhr von Bestrahlungsmodul-Kühlmedium (21) aus der Plattform (4) vorgesehen sind, wobei diese Bestrahlungsmodul-Kühlmedium-Eintrittsöffnungen (20) des Bestrahlungsmodules (6) funktionell zusammenwirkbar mit den Bestrahlungsmodul-Kühlmedium-Austrittsöffnungen (31) der Plattform (4) angeordnet und ausgebildet sind, wobei die Bestrahlungsmodul-Kühlmedium-Eintrittsöffnungen (20) mit den in dem Bereich der Vorderseite (5) und der Rückseite (9) der Vorrichtung (1) befindlichen Endbereichen (32) des Leuchtmittels (17) kühlmedium (21)-führend in Verbindung stehen, wobei knapp unterhalb (26) des Leuchtmittels (17) - zu dem Zwecke eines gasdichten Verschlusses der Strahlungs-Austrittsöffnung (16) des Bestrahlungsmodules (6) - eine für die von dem Leuchtmittel (17) emittierte Strahlung vollständig oder teilweise transparente Scheibe (15) und knapp oberhalb (25) des Leuchtmittels (17) ein Reflektor (18) vorgesehen ist, wobei das aus der Plattform (4) zugeführte, noch nicht erwärmte, frische, gasförmige oder flüssige Bestrahlungsmodul-Kühlmedium (21) den in Richtung der Rückseite (9) der Vorrichtung (1) und den in Richtung der Vorderseite (5) der Vorrichtung (1) gelegenen, jeweils offenen Endbereichen (32) eines Spaltes zwischen der unten liegenden (26) Glasscheibe (15) und dem oben liegenden (25) Bereich des Reflektors (18) zuführbar ist, wobei in dem - bei einer Seitenbetrachtung des Bestrahlungsmodules (6) - Mittenbereich (23) des Bestrahlungsmodules (6) eine Führung (24) oberhalb des Leuchtmittels (17) für das nach dem vollständigen oder teilweisen Entlangstreichen des Leuchtmittels (17) entlang der Unterseite und/oder der Oberseite des Leuchtmittels (17) in Richtung der Mitte (23) erwärmte Bestrahlungsmodul-Kühlmedium (22) nach oben (25) in Richtung der Plattform (4) vorgesehen ist, wobei eine zwischen den Vorderseiten (5) der Plattform (4) und der Bestrahlungsmodule (6) wirkende Verriegelungseinrichtung (38) in verriegelnder Position gezeigt ist, wobei diese Verriegelungseinrichtung (38) erst nach dem vollständigen Einschieben des Bestrahlungsmodules (6) in seine jeweilige Modul-Anbringungs-Einrichtung (10) in ihre geschlossene Verriegelungsposition bringbar ist und erst dann die Versorgung des Leuchtmittels (17) mit elektrischer Energie gewährleistet und wobei eine elektrisch leitende Kupplung (40) zwischen der Unterseite (8) der Plattform (4) und der Oberseite (19) des vollständig eingeschobenen Bestrahlungsmodules (6) dargestellt ist, welche lediglich dann die Abgabe von Strom an das Bestrahlungsmodul (6) gestattet, wenn das Bestrahlungsmodul (6) vollständig in die zugehörige Modul-Anbringungs-Einrichtung (10) eingeschobenen ist;
Figur 4 einen schematischen Schnitt entlang der in Figur 1 dargestellten Linie A-A, welcher eine obenliegende (25) Plattform (4) und ein - zu der Unterseite (8) der Plattform (4) korrespondierend ausgebildetes - Bestrahlungsmodul (6) zeigt, wobei in die Plattform (4) zwei Leitungen (29) für das noch nicht erwärmte, frische gasförmige oder flüssige Bestrahlungsmodul-Kühlmedium (21) von außen her einmünden, wobei in diese Leitungen (29) - innerhalb der Plattform (4) - jeweils ein Gebläse (30) oder eine Pumpe integrierbar ist, welches das Bestrahlungsmodul-Kühlmedium (21) in Richtung von zwei Bestrahlungsmodul-Kühlmedium-Austrittsöffnungen (31) der Plattform (4) beschleunigt oder komprimiert, wobei die beiden Bestrahlungsmodul-Kühlmedium-Austrittsöffnungen (31) jeweils auf der Unterseite (8) der Plattform (4) - und zum einen in dem Bereich der Rückseite (9) der Vorrichtung (1) und zum anderen in dem Bereich der Vorderseite (5) der Vorrichtung (1) - vorgesehen sind, wobei auf der Oberseite (19) des Bestrahlungsmodules (6) zwei Bestrahlungsmodul-Kühlmedium-Eintrittsöffnungen (20) für die Zufuhr von Bestrahlungsmodul-Kühlmedium (21) aus der Plattform (4) vorgesehen sind, wobei diese Bestrahlungsmodul-Kühlmedium-Eintrittsöffnungen (20) des Bestrahlungsmodules (6) funktionell zusammenwirkbar mit den Bestrahlungsmodul-Kühlmedium-Austrittsöffnungen (31) der Plattform (4) angeordnet und ausgebildet sind, wobei die Bestrahlungsmodul-Kühlmedium-Eintrittsöffnungen (20) mit den in dem Bereich der Vorderseite (5) und der Rückseite (9) der Vorrichtung (1) befindlichen Endbereichen (32) des Leuchtmittels (17) kühlmedium (21)-führend in Verbindung stehen, wobei knapp unterhalb (26) des Leuchtmittels (17) - zu dem Zwecke eines gasdichten Verschlusses der Strahlungs-Austrittsöffnung (16) des Bestrahlungsmodules (6) - eine für die von dem Leuchtmittel (17) emittierte Strahlung vollständig oder teilweise transparente Scheibe (15) und knapp oberhalb (25) des Leuchtmittels (17) ein Reflektor (18) vorgesehen ist, wobei das aus der Plattform (4) zugeführte, noch nicht erwärmte, frische, gasförmige oder flüssige Bestrahlungsmodul-Kühlmedium (21) zunächst den in Richtung der Rückseite (9) der Vorrichtung (1) und den in Richtung der Vorderseite (5) der Vorrichtung (1) gelegenen beiden Randbereichen der Glasscheibe (15) zuführbar ist, dann die Unterseite des Leuchtmittels (17) in Richtung der Mitte (23) des Bestrahlungsmodules (6) überstreicht, in dem Mittenbereich (23) das Leuchtmittel (17) in vertikal nach oben gerichteter Weise umströmt, dann - ausgehend von dem Mittenbereich (23) nach außen in Richtung der beiden Endbereiche (32) des Leuchtmittels (17) - die Oberseite des Leuchtmittels (17) und die Unterseite des Reflektors (18) überstreicht, dann die beiden Endbereiche (32) des Leuchtmittels (17) mit den elektrischen Kontakten des Leuchtmittels (17) überstreicht, dann in Richtung der Mitte (23) des Bestrahlungsmodules (6) - unter Kontakt mit auf der Rückseite des Reflektors (18) vorgesehenen Kühlrippen (7) oder statt diesen vorgesehenen Wärmetauschern - führbar ist und dann über eine mittige Führung (24) für die Abführung des erwärmten Bestrahlungsmodul-Kühlmediums (22) aus dem Bestrahlungsmodul (6) in Richtung der mittigen Führung (28) der Plattform (4) - für die Abführung des erwärmten Bestrahlungsmodul-Kühlmediums (22) nach außen - führbar ist, wobei eine zwischen den Vorderseiten (5) der Plattform (4) und der Bestrahlungsmodule (6) wirkende Verriegelungseinrichtung (38) in verriegelnder Position gezeigt ist, wobei diese Verriegelungseinrichtung (38) erst nach dem vollständigen Einschieben des Bestrahlungsmodules (6) in seine jeweilige Modul-Anbringungs-Einrichtung (10) in ihre geschlossene Verriegelungsposition bringbar ist und erst dann die Versorgung des Leuchtmittels (17) mit elektrischer Energie gewährleistet und wobei eine elektrisch leitende Kupplung (40) zwischen der Unterseite (8) der Plattform (4) und der Oberseite (19) des vollständig eingeschobenen Bestrahlungsmodules (6) dargestellt ist, welche lediglich dann die Abgabe von Strom an das Bestrahlungsmodul (6) gestattet, wenn das Bestrahlungsmodul (6) vollständig in die zugehörige Modul-Anbringungs-Einrichtung (10) eingeschobenen ist;

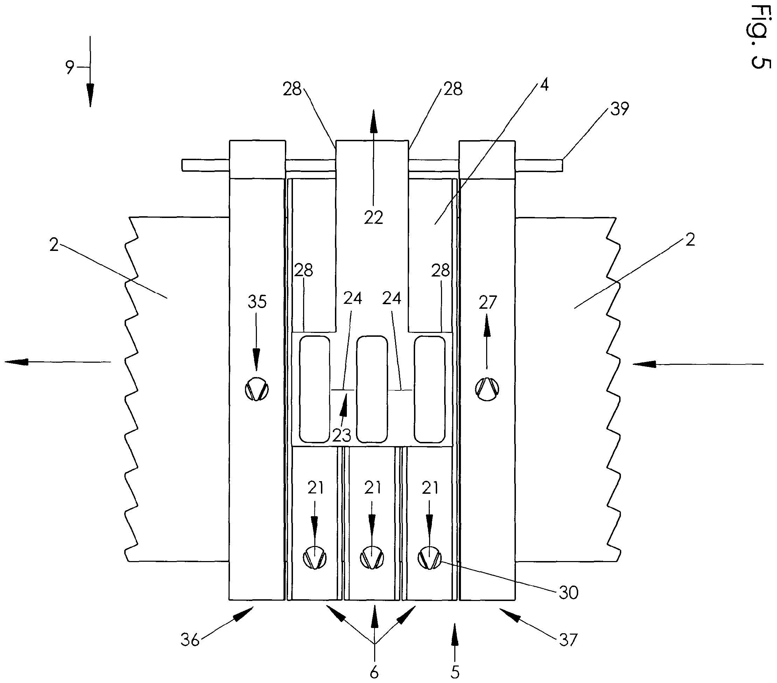

Figur 5 zeigt eine schematische, teilweise entlang der Linie B - B in Figur 1 horizontal geschnittene Draufsicht auf die in den Figuren 1, 3 und 4 dargestellte Vorrichtung (1) mit drei nebeneinander angeordneten Bestrahlungsmodulen (6), wobei einerseits von den drei Bestrahlungsmodulen (6) ein Substrat-Zuluft-Modul (36) und andererseits von den drei Bestrahlungsmodulen (6) ein Substrat-Abluft-Modul (37) vorgesehen ist, wobei in jedes Bestrahlungsmodul (6) noch nicht erwärmtes, frisches, gasförmiges oder flüssiges Bestrahlungsmodul-Kühlmedium (21) - nach der Passage jeweils eines Gebläses (30) oder einer Pumpe - einbringbar ist, wobei in den Mittenbereichen (23) jedes Bestrahlungsmodules (6) eine von dem untenliegenden (26) Leuchtmittel (17) oder Reflektor (18) ausgehende und sich nach oben (25) erstreckende Führung (24) zur Abführung des erwärmten Bestrahlungsmodul-Kühlmediums (22) vorgesehen ist, wobei die obenliegenden (25) Enden der Führung (24) für die Abführung des erwärmten Bestrahlungsmodul-Kühlmediums (22) jedes Bestrahlungsmodules (6) in eine - in dem Mittenbereich (23) der Plattform (4) vorgesehene - Leitung (28) der Plattform (4) für die Abführung von erwärmten Bestrahlungsmodul-Kühlmedium (22) münden, welche das erwärmte Bestrahlungsmodul-Kühlmedium (22) in einen außerhalb der Plattform (4) liegenden Bereich abführt.

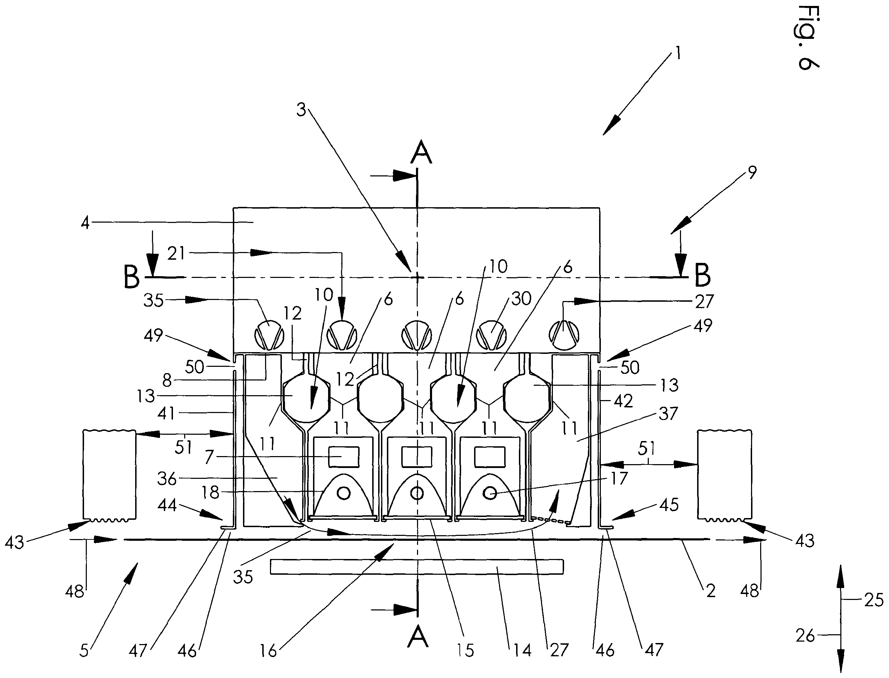

Figur 6 zeigt eine schematische Vorderansicht (5) einer Vorrichtung (1) zur Bestrahlung eines Substrates (2) gemäß Figur 1, welche - in Bezug auf die Transportrichtung (48) des zu bestrahlenden Substrates (2) - stromaufseitig von dem stromaufseitigen Modul (36) für die Zufuhr von Substrat-Zuluft (35), einen Druckkopf (43) und stromabseitig von dem stromabseitigen Modul (37) zur Absaugung von Substrat-Zuluft (35) einen Druckkopf (43) umfasst, wobei zwischen dem stromaufseitigen Druckkopf (43) und dem stromaufseitigen Modul (36) für die Zufuhr von Substrat-Zuluft (35) ein erstes Schott (41) oder eine erste Trennwand und zwischen dem stromabseitigen Druckkopf (43) und dem stromabseitigen Modul (37) zur Absaugung von Substrat-Zuluft (35), ein zweites Schott (42) oder eine zweite Trennwand vorgesehen ist, wobei zwischen den unteren, dem zu bestrahlenden Substrat (2) zugewandten Enden (44, 45) der Schotten (41, 42) oder Trennwände einerseits und dem zu bestrahlenden Substrat (2) andererseits ein Spalt (46) ausgebildet ist, wobei in den oberen, dem zu bestrahlenden Substrat (2) abgewandten End-Bereichen (49) der beiden Schotten (41, 42) oder Trennwände jeweils eine klein- oder großflächige Aussparung (50) oder Öffnung für die Passage von Luft vorgesehen ist. Gegenstand der vorliegenden Erfindung ist also eine Vorrichtung (1) zur Bestrahlung eines Substrates (2) gemäß Anspruch 1. Diese Vorrichtung (1) umfasst eine Plattform (4) mit einer Längsachse (3), wobei die Plattform (4) in Bezug auf ihre Längsachse (3) gerade oder gekrümmt ist, wobei ein, zwei, drei, vier, fünf, sechs, sieben, acht, neun, zehn oder mehrere Bestrahlungs-Module (6) und Substrat-Zuluft-Module (36) und Substrat-Abluft-Module (37) mittelbar oder unmittelbar an einer Unterseite (8) der Plattform (4) reversibel anbringbar sein.

Die Anbringung dieser Module (6, 36, 37) erfolgt durch Einschieben oder Einstecken oder Einhängen dieser Module (6, 36, 37) in eine oder mehrere an der Unterseite (8) der Plattform (4) vorgesehene feststehende oder teleskopierbare Modul-Anbringungs-Einrichtungen (10) (siehe insbesondere Figuren 1 und 2).

Dieses Einschieben, Einstecken oder Einhängen der Module (6, 36, 37) in die jeweilige Modul-Anbringungs-Einrichtung (10) findet jeweils von einer Vorderseite (5) der Vorrichtung (1) ausgehend und in Richtung einer Rückseite (9) der Vorrichtung (1) verlaufend, statt.

Wie bereits aus den Figuren 1 und 2 hervorgeht, können die eine oder die mehreren Modul-Anbringungs-Einrichtungen (10) jeweils eine rechtwinklig zu der Unterseite (8) der Plattform (4) ausgerichtete Wand (12) umfassen.

Im Allgemeinen können diese Wände (12) - jeweils in ihrem nach unten weisenden Bereich - einen sich beidseitig erstreckenden, wulstartigen Vorsprung (13) und/oder eine linienförmige Aussparung für das Tragen von hin- und herschiebbaren und darin einschiebbaren Modulen (6, 36, 37) tragen.

In der Regel kann dann jedes Modul (6, 36, 37) jeweils eine oder mehrere - korrespondierend zu dem vorsprungartigen oder aussparungsförmigen Trägerelement der Wand (12) ausgebildete - leisten- und/oder linienförmige Aussparungen (11) oder Vorsprünge aufweisen.

Im Allgemeinen können ein oder mehrere Leitungen (29) für die Zuführung von noch nicht erwärmtem, frischem, gasförmigem oder flüssigem Bestrahlungsmodul-Kühlmedium (21) innerhalb und/oder außerhalb der Plattform (4) vorgesehen sein.

Das gasförmige oder flüssige Bestrahlungsmodul-Kühlmedium (21) kann beispielsweise Luft, Stickstoff, Flüssigstickstoff, ein oder mehrere Edelgase - oder eine Mischung hiervon - oder eine Flüssigkeit, beispielsweise Wasser, strömendes Wasser oder mit Kondensaten - beispielsweise Acetaldehyd - versetztes Wasser, sein.

Innerhalb und/oder stromaufseitig und außerhalb der Plattform (4) können - vorzugsweise integriert in diese Leitungen (29) - ein oder mehrere separate Gebläse (30) für das noch nicht erwärmte, frische Bestrahlungsmodul-Kühlmedium (21) vorgesehen sein.

Beispielsweise aus den Figuren 3 und 4 ist ersichtlich, dass in jede Plattform (4) von außen her eine oder mehrere externe Leitungen (29) für die Führung des noch nicht erwärmten, frischen Bestrahlungsmodul-Kühlmediums (21) einmünden können.

Wie bereits ausgeführt, können in die eine oder die mehreren Leitungen (29) für die Führung des noch nicht erwärmten, frischen Bestrahlungsmodul-Kühlmediums (21) - dann innerhalb oder außerhalb der Plattform (4) - jeweils ein oder mehrere Gebläse (30) integrierbar sein.

In der Regel können diese Gebläse (30) oder Pumpen das noch nicht erwärmte, frische Bestrahlungsmodul-Kühlmedium (21) in Richtung von einer oder mehreren - auf der Unterseite (8) der Plattform (4) und zumindest in dem Bereich der Rückseite (9) der Vorrichtung (1) und/oder in dem Bereich der Vorderseite (5) der Vorrichtung (1), vorgesehenen - Austrittsöffnungen (31) für noch nicht erwärmtes und frisches Bestrahlungsmodul-Kühlmedium (21) beschleunigen und/oder komprimieren.

Insbesondere aus den Figuren 3 und 4 geht hervor, dass auf der Oberseite (19) jedes Bestrahlungsmodules (6) eine oder mehrere Bestrahlungsmodul-Kühlmedium-Eintritts-Öffnungen (20) für die Zufuhr des noch nicht erwärmten, frischen Bestrahlungsmodul-Kühlmediums (21) aus der Plattform (4) vorgesehen sein können.

Wie insbesondere in diesen Figuren 3 und 4 dargestellt, können diese Bestrahlungsmodul-Kühlmedium-Eintritts-Öffnungen (20) jedes Bestrahlungsmodules (6) funktionell zusammenwirkbar mit den Austrittsöffnungen (31) der Plattform (4) für noch nicht erwärmtes und frisches Bestrahlungsmodul-Kühlmittel (21) angeordnet und ausgebildet sein.

Vorzugsweise können die Bestrahlungsmodul-Kühlmedium-Eintritts-Öffnungen (20) mit den in dem Bereich der Vorderseite (5) und/oder der Rückseite (9) der Vorrichtung (1) befindlichen Endbereichen (32) des Leuchtmittels (17) noch nicht erwärmtes und frisches Kühlmedium (21)-führend in Verbindung stehen, wobei in diesen Endbereichen (32) in der Regel die elektrischen Kontakte zwischen dem Leuchtmittel (17) und dessen bestrahlungsmodul-seitiger Fassung vorgesehen sein können.

In bevorzugten Ausführungsformen kann knapp unterhalb (26) des Leuchtmittels (17) - zu dem Zwecke eines gasdichten Verschlusses der Strahlungs-Austrittsöffnung (16) des Bestrahlungsmodules (6) sowie zu dem Zwecke einer Führung des Bestrahlungsmodul-Kühlmediums (21) in einem geschlossenen Kreislauf innerhalb des Bestrahlungsmodules (6) - eine für die von dem Leuchtmittel (17) emittierte Strahlung vollständig oder teilweise transparente Scheibe (15) vorgesehen sein.

Die Figuren 1 bis 4 zeigen, dass knapp oberhalb des Leuchtmittels (17) ein Reflektor (18) - mit oder ohne Kühlrippen (7) oder Wärmetauscher - vorgesehen sein kann.

Insbesondere die Figuren 3 und 4 zeigen, dass das noch nicht erwärmte, frische Bestrahlungsmodul-Kühlmedium (21) in der Regel zunächst dem in Richtung der Rückseite (9) der Vorrichtung (1) und/oder dem in Richtung der Vorderseite (5) der Vorrichtung (1) gelegenen, jeweils offenen Endbereich (32) des Spaltes zwischen der unteren (26) Glasscheibe (15) und dem Reflektor (18) zuführbar sein kann.

Insbesondere gemäß den Figuren 3, 4 und 5 ist zu entnehmen, dass in dem - bei einer Seitenbetrachtung des Bestrahlungsmodules (6) oberhalb des Reflektors (18) und/oder der Kühlrippen (7) und/oder des Wärmetauschers befindlichen Mittenbereich (23) des Bestrahlungsmodules (6) eine Führung (24) für die vertikal nach oben in Richtung der Plattform (4) gerichtete Abführung des nach dem vollständigen oder teilweisen sowie einmaligen oder mehrmaligen Überstreichens des Leuchtmittels (17) erwärmten Bestrahlungsmodul-Kühlmediums (22), vorgesehen sein kann.

Figur 4 zeigt, dass in einer besonders bevorzugten Ausführungsform der erfindungsgemäßen Vorrichtung (1) das noch nicht erwärmte, frische Bestrahlungsmodul-Kühlmedium (21) zunächst den in Richtung der Rückseite (9) der Vorrichtung (1) und den in Richtung der Vorderseite (5) der Vorrichtung (1) gelegenen beiden Randbereichen der Glasscheibe (15) zuführbar sein kann.

Stromabseitig kann dann das frische Bestrahlungsmodul-Kühlmedium (21) die Unterseite des Leuchtmittels (17) in Richtung der Mitte (23) des Bestrahlungsmodules (6) überstreichen.

Vorzugsweise kann stromabseitig von der Mitte (23) das frische Bestrahlungsmodul-Kühlmedium (21) in dem Mittenbereich (23) das Leuchtmittel (17) in vertikal nach oben gerichteter Weise umströmen.

Anschließend kann das frische Bestrahlungsmodul-Kühlmedium (21) - ausgehend von dem Mittenbereich (23) - nach außen in Richtung der beiden Endbereiche (32) des Leuchtmittels (17), die Oberseite des Leuchtmittels (17) und die Unterseite des Reflektors (18) überstreichen.

Im stromabseitigen Anschluss kann das Bestrahlungsmodul-Kühlmedium (21) die beiden Endbereiche (32) des Leuchtmittels (17) mit den elektrischen Kontakten des Leuchtmittels (17) überstreichen.

Vorzugsweise kann das Bestrahlungsmodul-Kühlmedium (21) stromabseitig dann in Richtung der Mitte (23) des Bestrahlungsmodules (6) - unter Kontakt mit auf der Rückseite des Reflektors (18) vorgesehenen Kühlrippen (7) oder statt diesen vorgesehenen Wärmetauschern - führbar sein.

Wie aus Figur 4 deutlich erkennbar, kann dann das erwärmte Bestrahlungsmodul-Kühlmedium (22) über eine mittige Führung (24) aus dem Bestrahlungsmodul (6) in Richtung der mittigen Führung (28) der Plattform (4) - für die Abführung des erwärmten Bestrahlungsmodul-Kühlmediums (22) nach außen - führbar sein.

In einer - grafisch hier nicht dargestellten - weiteren bevorzugten Ausführungsform können in die Plattform (4) eine oder mehrere Leitungen (29) für die Führung des noch nicht erwärmten, frischen Bestrahlungsmodul-Kühlmediums (21) einmünden oder in die Plattform (4) integriert sein.

In diesen Leitungen (29) können dort - außerhalb und/oder innerhalb der Plattform (4) - jeweils ein oder mehrere Gebläse (30) und/oder Pumpen vorgesehen sein.

Im Allgemeinen verlaufen diese Leitungen (29) in der Plattform (4) - bei einer Seitenbetrachtung - in Richtung der Mitte (23) der Plattform (4).

In dieser - hier grafisch nicht dargestellten - bevorzugten Ausführungsform der erfindungsgemäßen Vorrichtung (1) können diese Leitungen (29) - mittelbar über eine mittige Führung (28) oder unmittelbar - in eine in dem Mittenbereich (23) der Plattform (4) befindliche Austrittsöffnung auf der Unterseite (8) der Plattform (4) münden.

In der Regel können dort auf der Oberseite (19) und in dem Mittenbereich (23) des Bestrahlungsmodules (6) eine oder mehrere - zu der Austrittsöffnung auf der Unterseite (8) der Plattform (4) korrespondierende und mit dieser zusammenwirkende - Eintrittsöffnungen für aus der Plattform (4) austretendes, noch nicht erwärmtes, frisches Bestrahlungsmodul-Kühlmedium (21) vorgesehen sein.

Bei dieser Ausführungsform kann stromabwärts von der mittigen Eintrittsöffnung des Bestrahlungsmoduls (6) eine vertikale, nach unten (26) weisende Führung (24) - für die Führung des noch nicht erwärmten, frischen Bestrahlungsmodul-Kühlmediums (21) aus der Austrittsöffnung auf der Unterseite (8) der Plattform (4) - vorgesehen sein.

Vorzugsweise kann bei dieser Ausführungsform in dem unteren Endbereich dieser Führung eine Vorrichtung zur Aufspaltung des vertikal nach unten strömenden Bestrahlungsmodul-Kühlmedium-Stromes in einen in Richtung der Rückseite (9) und in einen in Richtung der Vorderseite (5) der Vorrichtung (1) gerichteten Bestrahlungsmodul-Kühlmedium-Teilstrom vorgesehen sein.

Im Falle dieser Ausführungsform kann jeder dieser Bestrahlungsmodul-Kühlmedium-Teilströme - während seiner Strömung in Richtung des jeweiligen rückseitigen (9) oder vorderseitigen (5) offenen Endbereiches (32) - die mit der Rückseite des Reflektors (18) mittelbar oder unmittelbar in Verbindung stehenden Kühlrippen (7) oder Wärmetauscher durchströmen.

Vorzugsweise kann dann stromabseitig das Bestrahlungsmodul-Kühlmedium (21) den jeweiligen frontseitigen (5) oder rückseitigen (9) Endbereich (32) - mit den elektrischen Kontakten für die Stromversorgung des Leuchtmittels (17) - durchströmen. Das Bestrahlungsmodul-Kühlmedium (21) kann dann stromabseitig den oberhalb des Leuchtmittels (17) befindlichen Strahler-Bereich zwischen der Unterseite des Reflektors (18) und der Oberseite des Leuchtmittels (17) - ausgehend von dem vorderseitigen (5) oder rückseitigen (9) Endbereich (32) - in Richtung der Mitte (23) des Bestrahlungsmodules (6) durchströmen.

In diesem Mittenbereich (23) kann bei dieser Ausführungsform das Bestrahlungsmodul-Kühlmedium (21) dann das Leuchtmittel (17) - in vertikal nach unten weisender Richtung und in Richtung der die Strahlungs-Austrittsöffnung (16) verschließenden Glasscheibe (15) - umströmen.

Vorzugsweise kann dann das Bestrahlungsmodul-Kühlmedium (21) den unterhalb des Leuchtmittels (17) befindlichen Strahler-Bereich zwischen der Glasscheibe (15) und der Unterseite des Leuchtmittels (17) durchströmen.

Im Allgemeinen können bei dieser Ausführungsform stromabseitig eine oder mehrere vorderseitige (5) und/oder rückseitige (9) Führungen zur vertikalen, nach oben gerichteten Führung des erwärmten Bestrahlungsmodul-Kühlmedium-Teilstromes (22) in Richtung einer oder mehrerer, auf der Oberseite (19) des Bestrahlungsmodules (6) befindlicher, Austrittsöffnungen vorgesehen sein.

Bei dieser Ausführungsform können auf der Unterseite (8) der Plattform (4) eine oder mehrere - jeweils in dem Bereich der Vorderseite (5) und/oder der Rückseite (9) der Vorrichtung (1) befindliche - Eintrittsöffnungen für das - aus den auf der Oberseite (19) des Bestrahlungsmodules (6) befindlichen Austrittsöffnungen ausströmende - erwärmte Bestrahlungsmodul-Kühlmedium (22) vorgesehen sein.

In diesen besonders bevorzugten derartigen Ausführungsformen können diese Eintrittsöffnungen der Plattform (4) - für erwärmtes Bestrahlungsmodul-Kühlmedium (22) - mit Leitungen für die Führung von erwärmtem Bestrahlungsmodul-Kühlmedium (22) durch die Plattform (4) in einen außerhalb der Plattform (4) liegenden Bereich, in Verbindung stehen.

Bei den bevorzugten Ausführungsformen der erfindungsgemäßen Vorrichtung (1) gemäß Figuren 1 bis 5 kann also - bei einer Seitenbetrachtung der Plattform (4) - in dem Mittenbereich (23) der Plattform (4) eine - in Bezug auf die Plattform (4) nach außen verlaufende - Führung (28) für die Abführung des erwärmten Bestrahlungsmodul-Kühlmediums (22) vorgesehen sein, welches aus der vertikal nach oben gerichteten, mittigen (23) Führung (24) des Bestrahlungsmodules (6) für die Abführung von erwärmten Bestrahlungsmodul-Kühlmedium (22) stammt.

Im Falle dieser bevorzugten Ausführungsform kann die auf der Unterseite (8) der Plattform (4) liegende Eintrittsöffnung (33) der Plattform (4) für das erwärmte Bestrahlungsmodul-Kühlmedium (22) funktionell zusammenwirkend mit der auf der Oberseite (19) des Bestrahlungsmodules (6) befindlichen Öffnung (34) - der Führung (24) für die Abführung des erwärmten Bestrahlungsmodul-Kühlmediums (22) aus dem Bestrahlungsmodul (6) - angeordnet und ausgebildet sein.

Insbesondere den Figuren 3 und 4 ist zu entnehmen, dass die Vorrichtung (1) eine oder mehrere einerseits zwischen der Vorderseite (5) jedes Modules (6, 36, 37) und andererseits zwischen der Vorderseite (5) der Plattform (4) wirkende Verriegelungseinrichtungen (38) umfassen kann.

Diese Verriegelungseinrichtungen (38) sind vorzugsweise derart ausgestaltet, dass nur in der verriegelnden Stellung der Verriegelungseinrichtung (38) eine elektrische Versorgung der Module (6, 36, 37) mittelbar oder unmittelbar über die Plattform (4) erfolgen kann.

Die Figuren 3 und 4 zeigen, dass die Vorrichtung (1) eine oder mehrere elektrisch leitende Kupplungen (40) umfassen kann, welche zwischen der Unterseite (8) der Plattform (4) einerseits und der Oberseite (19) des Bestrahlungsmodules (6) andererseits - nur bei vollständigem Einschub des Bestrahlungsmodules (6) in seine jeweilige Modul-Anbringungs-Einrichtung (10) - elektrisch leitend wirken können.

In der Regel können das eine oder die mehreren Leuchtmittel (17) für die Emission elektromagnetischer Strahlung jedes Bestrahlungsmodules (6) gleich oder voneinander verschieden sein.

Vorzugsweise können die Leuchtmittel (17) jeweils in Form einer oder mehrerer elektromagnetische Strahlung emittierender Dioden (LED) und/oder Halogen-Strahler und/oder Halogen-Röhren ausgebildet sein.

In besonders bevorzugten Ausführungsformen der erfindungsgemäßen Vorrichtung (1) können die Leuchtmittel (17) beispielsweise jeweils in Form eines oder mehrerer Mikrowellen-Strahler (12 mm bis 1 mm) und/oder IR-Strahler (760 nm bis 0,5 mm; nahes Infrarot NIR: 760 nm bis 2,5 µm; mittleres Infrarot MIR: 2,5 µm bis 25 µm; fernes Infrarot FIR: 25 µm bis 500 µm) und/oder Strahler für sichtbares Licht (400 nm bis 750 nm) und/oder UV-Strahler (400 nm bis 10 nm) und/oder Röntgen-Strahler (100 nm bis 10⁻² pm) ausgebildet sein.

Insbesondere den Figuren 3 und 4 ist zu entnehmen, dass in dem Bereich der Rückseite (9) der Vorrichtung (1) zur Bestrahlung eines Substrates (2) eine vertikal ausgerichtete Befestigungsplatte (39) vorgesehen sein kann.

Vorzugsweise können an dieser vertikalen Befestigungsplatte (39) die Rückseiten der Plattform (4) und/oder der Module (6, 36, 37) - mittelbar beispielsweise über Modul-Anbringungs-Einrichtungen (10) - oder unmittelbar anbringbar sein.

Sofern die Vorrichtung (1) zur Bestrahlung eines Substrates (2) einen stromaufseitigen Druckkopf (43) und/oder einen stromabseitigen Drucckopf (43) umfasst, kann aus dem Substrat-Zuluft-Modul (36) austretende Zuluft (35) mittelbar oder unmittelbar zu Verblasungen oder Verwehungen zwischen dem zu bestrahlenden Substrat (2) und dem oder den Druckköpfen (43) führen. Beispielsweise kann die aus dem Substrat-Zuluft-Modul (36) ausströmende Substrat-Zuluft (35) Umgebungsluft mitreißen, wodurch ein Unterdruck im Einströmungsbereich der Substrat-Zuluft (35) entstehen kann und welcher sich auf den oder die Druckköpfe (43) nachteilig auswirken kann. Diese Verblasungen oder Verwehungen sind insbesondere deswegen störend und gefürchtet, weil sie das von den Druckköpfen (43) auf dem zu bestrahlenden Substrat (2) erzeugte Druckergebnis nachteilig beeinflussen.

Die erfindungsgemäße Vorrichtung (1) zur Bestrahlung eines Substrates (2) umfasst - wie in Figur 6 dargestellt und in Bezug auf die Transportrichtung (48) des zu bestrahlenden Substrates (2) - stromaufseitig von dem stromaufwärtigsten, d.h. am weitesten stromaufwärts angeordneten, Substrat-Zuluft-Modul (36) für die Zufuhr von Substrat-Zuluft (35), einen oder mehrere Druckköpfe (43) und stromabseitig von dem stromabwärtigsten, d.h. am weitesten stromabwärts angeordneten Substrat-Abluft-Modul (37) zur Absaugung von Substrat-Zuluft (35) einen oder mehrere Druckköpfe (43).

Zwischen dem oder den stromaufseitigen Druckköpfen (43) und dem stromaufwärtigsten Substrat-Zuluft-Modul (36) für die Zufuhr von Substrat-Zuluft (35) ist ein erstes Schott (41) oder eine erste Trennwand für die mittelbare oder unmittelbare Verbindung mit der Umgebungsluft vorgesehen.

Zusätzlich zu diesem ersten Schott (41) ist zwischen dem oder den stromabseitigen Druckköpfen (43) und dem stromabwärtigsten Substrat-Abluft-Modul (37) zur Absaugung von Substrat-Zuluft (35), ein zweites Schott (42) oder eine zweite Trennwand für die mittelbare oder unmittelbare Verbindung mit der Umgebungsluft vorgesehen.

Figur 6 zeigt, dass zwischen den unteren, dem zu bestrahlenden Substrat (2) zugewandten Enden (44, 45) der Schotten (41, 42) oder Trennwände einerseits und dem zu bestrahlenden Substrat (2) andererseits ein Spalt (46) ausgebildet ist. Die vertikale Höhe dieses Spaltes (46) liegt in dem Bereich von 0,1 mm bis 5,0 mm. In der Regel kann die vertikale Höhe des Spaltes (46) möglichst gering bemessen sein, um die Verblasungsgefahr in dem Bereich der oder des Druckkopfes (43) durch Unterdruck oder Überdruck in dem Bereich zwischen dem Substrat-Zuluft-Modul (36) und dem Substrat-Abluft-Modul (37) auszuschließen.

Aus Figur 6 geht ferner hervor, dass in den oberen, dem zu bestrahlenden Substrat (2) abgewandten End-Bereichen (49) der beiden Schotten (41, 42) oder Trennwände jeweils eine oder mehrere klein- oder großflächige Aussparungen (50) oder Öffnungen für die Passage von Umgebungs-Luft zum Unter- oder Überdruck-Ausgleich vorgesehen sind

Diese Aussparungen (50) für die Passage von Umgebungs-Luft sind für den Unter- oder Überdruck-Ausgleich beispielsweise zwischen dem Raum zwischen Substrat-Zuluft-Modul (36) und Substrat-Abluft-Modul (37) einerseits und der Umgebung andererseits angezeigt.

Figur 6 zeigt auch, dass die unteren Enden (44, 45) der Schotten (41, 42) oder Trennwände jeweils eine Vorrichtung (47) zum Absperren oder Regeln von das zu bestrahlende Substrat (2) überstreichender Luft tragen können.

Diese Vorrichtungen (47) zum Absperren oder Regeln von Luft für den Unter- oder Überdruck-Ausgleich können jeweils eine horizontale Länge aufweisen, die beispielsweise in dem Bereich von 0,5 mm bis 10,0 cm, vorzugsweise in dem Bereich von 1,0 mm bis 8,0 cm, insbesondere in dem Bereich von 1,5 mm bis 6,0 cm, liegt.

In besonders bevorzugten Ausführungsformen der erfindungsgemäßen Vorrichtung (1) kann der vertikale Abstand zwischen den Luft-Passage-Aussparungen (50) oder Öffnungen in den oberen Endbereichen (49) der Schotten (41, 42) oder Trennwände einerseits und den Vorrichtungen (47) zum Absperren und/oder Regeln von das zu bestrahlende Substrat (2) überstreichender Luft an den unteren Enden (44, 45) der Schotten (41, 42) oder Trennwände andererseits beispielsweise in dem Bereich von 1,0 cm bis 1,5 m, vorzugsweise in dem Bereich von 1,5 cm bis 1,0 m, insbesondere in dem Bereich von 2,0 cm bis 80,0 cm, liegen.

In besonders bevorzugten Ausführungsformen der erfindungsgemäßen Vorrichtung (1) kann der horizontale Abstand zwischen dem stromaufseitigen Schott (41) oder der stromaufseitgen Trennwand einerseits und der stromaufseitigen Außenwand des stromaufseitigen Substrat-Zuluft-Moduls (36) andererseits sowie zwischen dem stromabseitigen Schott (42) oder der stromabseitigen Trennwand einerseits und der stromabseitigen Außenwand des stromabseitigen Substrat-Abluft-Moduls (37) andererseits, beispielsweise jeweils in dem Bereich von 0,5 mm bis 20,0 cm, vorzugsweise in dem Bereich von 1,0 mm bis 15,0 cm, insbesondere in dem Bereich von 1,5 mm bis 12,0 cm, liegen.

Die horizontalen Abstände (51) zwischen den Schotten (41, 42) oder Trennwänden einerseits und dem oder den Druckköpfen (43) andererseits können beispielsweise in dem Bereich von 0,5 mm bis 20,0 cm, vorzugsweise in dem Bereich von 1,0 mm bis 15,0 cm, insbesondere in dem Bereich von 1,5 mm bis 10,0 cm, liegen.

Zusammenfassend ist festzustellen, dass eine Vorrichtung (1) zur Bestrahlung von Substraten (2) zur Verfügung gestellt wird, welche - in dem Falle einer Störung einer oder mehrerer Bestrahlungseinrichtungen - eine besonders einfache, schnelle, mühelose und Fehlermöglichkeiten ausschließende Reparatur gestattet.

Ein weiterer gravierender Vorteil der oben beschriebenen Vorrichtung (1) zur Bestrahlung von Substraten (2) besteht darin, dass die Bestrahlungsmodule (6) auf besonders einfache, schnelle, mühelose und Fehlermöglichkeiten ausschließende Art und Weise an unterschiedlichste Strahlungsbedingungen beziehungsweise Strahlungsbeschaffenheiten - insbesondere an verschiedene Wellenlängen und Intensitäten - angepasst werden können. Diese Vorteile werden insbesondere durch die besonders einfache, schnelle, mühlelose und Fehlermöglichkeiten ausschließende Einschiebbarkeit von äußerlich identischen Bestrahlungsmodulen (6) mit jeweils unterschiedlichen Leuchtmitteln (17) in die Modul-Anbringungs-Einrichtungen (10) realisiert.

Diese Vorteile werden bei der Vorrichtung (1) insbesondere dadurch erreicht, dass dort ein defektes Bestrahlungsmodul (6) - auf besonders einfache, schnelle, mühelose und Fehlermöglichkeiten ausschließende Art und Weise - aus der Modul-Anbringungs-Einrichtung (10) - in Richtung der Vorderseite (5) der Vorrichtung (1) - nach vorne hin entnehmbar ist.

Nach dem Austausch des defekten Bestrahlungsmodules (6) gegen ein intaktes Bestrahlungsmodul (6) - oder nach Reparatur des defekten, entnommenen Bestrahlungsmodules (6) - kann das intakte Bestrahlungsmodul (6) auf besonders einfache, schnelle, mühelose und Fehlermöglichkeiten ausschließende Art und Weise, durch einfaches Einschieben in die Modul-Anbringungs-Einrichtung (10) der Vorrichtung (1) - von der Vorderseite (5) der Vorrichtung (1) ausgehend und in Richtung der Rückseite (9) der Vorrichtung (1) fortschreitend - wieder an der Plattform (4) angebracht und dabei automatisch korrekt ausgerichtet werden.

Die vorgesehenen Schotten (41, 42) oder Trennwände führen zu dem gravierenden Vorteil, dass Verblasungen oder Verwehungen in den Bereichen von Druckköpfen (43) sicher vermieden werden und daher besonders konturenscharfe und präzise Druckergebnisse erzielbar sind.

## Patentansprüche

1. Vorrichtung (1) zur Bestrahlung eines Substrates (2), welche eine Plattform (4) mit einer Längsachse (3) umfasst, wobei die Plattform (4) in Bezug auf ihre Längsachse (3) gerade oder gekrümmt ist, wobei ein, zwei, drei, vier, fünf, sechs, sieben, acht, neun, zehn oder mehrere Bestrahlungs-Module (6) und Substrat-Zuluft-Module (36) und Substrat-Abluft-Module (37) mittelbar oder unmittelbar an einer Unterseite (8) der Plattform (4) durch Einschieben oder Einstecken oder Einhängen in eine oder mehrere an der Unterseite (8) der Plattform (4) vorgesehene, feststehende oder teleskopierbare Modul-Anbringungs-Einrichtungen (10) - jeweils von einer Vorderseite (5) der Vorrichtung (1) ausgehend und in Richtung einer Rückseite (9) der Vorrichtung (1) verlaufend - reversibel anbringbar sind, **dadurch gekennzeichnet, dass** diese Vorrichtung (1) - in Bezug auf die Transportrichtung (48) des zu bestrahlenden Substrates (2) - stromaufseitig von dem stromaufwärtigsten, d.h. am weitesten stromaufwärts angeordneten, Substrat-Zuluft-Modul (36) für die Zufuhr von Substrat-Zuluft (35), einen oder mehrere Druckköpfe (43) und stromabseitig von dem stromabwärtigsten, d.h. am weitesten stromabwärts angeordneten, Substrat-Abluft-Modul (37) zur Absaugung von Substrat-Zuluft (35) einen oder mehrere Druckköpfe (43) umfasst, wobei zwischen dem oder den stromaufseitigen Druckköpfen (43) und dem Substrat-Zuluft-Modul (36) für die Zufuhr von Substrat-Zuluft (35) ein erstes Schott (41) oder eine erste Trennwand und zwischen dem oder den stromabseitigen Druckköpfen (43) und dem stromabwärtigsten Substrat-Abluft-Modul (37) zur Absaugung von Substrat-Zuluft (35), ein zweites Schott (42) oder eine zweite Trennwand vorgesehen ist, wobei zwischen den unteren, dem zu bestrahlenden Substrat (2) zugewandten Enden (44, 45) der Schotten (41, 42) oder Trennwände einerseits und dem zu bestrahlenden Substrat (2) andererseits ein Spalt (46) ausgebildet ist, wobei die vertikale Höhe dieses Spaltes (46) in dem Bereich von 0,1 mm bis 5,0 mm liegt, wobei in den oberen, dem zu bestrahlenden Substrat (2) abgewandten End-Bereichen (49) der beiden Schotten (41, 42) oder Trennwände jeweils eine oder mehrere klein- oder großflächige Aussparungen (50) oder Öffnungen für die Passage von Luft vorgesehen sind.

2. Vorrichtung (1) zur Bestrahlung eines Substrates (2) nach Anspruch 1, **dadurch gekennzeichnet, dass** die eine oder die mehreren Modul-Anbringungs-Einrichtungen (10) jeweils eine rechtwinklig zu der Unterseite (8) der Plattform (4) ausgerichtete Wand (12) umfassen, welche in ihrem nach unten weisenden Bereich jeweils einen sich beidseitig erstreckenden, wulstartigen Vorsprung (13) und/oder eine linienförmige Aussparung für das Tragen von hin- und herschiebbaren und darin einschiebbaren Modulen (6, 36, 37) trägt, wobei jedes Modul (6, 36, 37) jeweils eine oder mehrere korrespondierend zu dem vorsprungartigen oder aussparungsförmigen Trägerelement der Wand (12) ausgebildete, leisten- und/oder linienförmige Aussparungen (11) oder Vorsprünge aufweist.

3. Vorrichtung (1) zur Bestrahlung eines Substrates (2) nach einem der Ansprüche 1 oder 2, **dadurch gekennzeichnet, dass** - in Bezug auf die Zuführung von noch nicht erwärmtem, frischem, gasförmigem oder flüssigem Bestrahlungsmodul-Kühlmedium (21) über eine oder mehrere Leitungen (29) für die Führung des noch nicht erwärmten, frischen Bestrahlungsmodul-Kühlmediums (21) zu der Plattform (4) - stromaufseitig von der Plattform (4) ein oder mehrere separate Gebläse (30) für das noch nicht erwärmte, frische Bestrahlungsmodul-Kühlmedium (21) vorgesehen sind oder wobei in jede Plattform (4) eine oder mehrere Leitungen (29) für die Führung des noch nicht erwärmten, frischen Bestrahlungsmodul-Kühlmediums (21) von außen her einmünden, wobei in die eine oder die mehreren Leitungen (29) für die Führung des noch nicht erwärmten, frischen Bestrahlungsmodul-Kühlmediums (21) - dann innerhalb oder außerhalb der Plattform (4) - jeweils ein oder mehrere Gebläse (30) integrierbar sind, welche das noch nicht erwärmte, frische Bestrahlungsmodul-Kühlmedium (21) in Richtung von einer oder mehreren Austrittsöffnungen (31) der Plattform (4) für noch nicht erwärmtes und frisches Bestrahlungsmodul-Kühlmedium (21) beschleunigen und/oder komprimieren, wobei die eine oder die mehreren Austrittsöffnungen (31) der Plattform (4) für noch nicht erwärmtes, frisches Bestrahlungsmodul-Kühlmedium (21) auf der Unterseite (8) der Plattform (4) und zumindest in dem Bereich der Rückseite (9) der Vorrichtung (1) und/oder in dem Bereich der Vorderseite (5) der Vorrichtung (1), vorgesehen sind.

4. Vorrichtung (1) zur Bestrahlung eines Substrates (2) nach einem der Ansprüche 1, 2 oder 3, **dadurch gekennzeichnet, dass** auf der Oberseite (19) jedes Bestrahlungsmodules (6) eine oder mehrere Bestrahlungsmodul-Kühlmedium-Eintritts-Öffnungen (20) für die Zufuhr des noch nicht erwärmten, frischen Bestrahlungs-modul-Kühlmediums (21) aus der Plattform (4) vorgesehen sind, wobei diese Bestrahlungsmodul-Kühlmedium-Eintritts-Öffnungen (20) jedes Bestrahlungsmodules (6) funktionell zusammenwirkbar mit den Austrittsöffnungen (31) der Plattform (4) für noch nicht erwärmtes und frisches Bestrahlungsmodul-Kühlmittel (21) angeordnet und ausgebildet sind, wobei die Bestrahlungsmodul-Kühlmedium-Eintritts-Öffnungen (20) mit den in dem Bereich der Vorderseite (5) und/oder der Rückseite (9) der Vorrichtung (1) befindlichen Endbereichen (32) des Leuchtmittels (17) noch nicht erwärmtes und frisches Kühlmedium (21)-führend in Verbindung stehen, wobei knapp unterhalb (26) des Leuchtmittels (17) - zu dem Zwecke eines gasdichten Verschlusses der Strahlungs-Austrittsöffnung (16) des Bestrahlungsmodules (6) sowie zu dem Zwecke einer Führung des Bestrahlungsmodul-Kühlmediums (21) in einem geschlossenen Kreislauf innerhalb des Bestrahlungsmodules (6) - eine für die von dem Leuchtmittel (17) emittierte Strahlung vollständig oder teilweise transparente Scheibe (15) und knapp oberhalb des Leuchtmittels (17) ein Reflektor (18) - mit oder ohne Kühlrippen (7) oder Wärmetauscher - vorgesehen ist, wobei das noch nicht erwärmte, frische Bestrahlungsmodul-Kühlmedium (21) dem in Richtung der Rückseite (9) der Vorrichtung (1) und/oder dem in Richtung der Vorderseite (5) der Vorrichtung (1) gelegenen, jeweils offenen Endbereich (32) des Spaltes zwischen der unteren (26) Glasscheibe (15) und dem Reflektor (18) zuführbar ist, wobei in dem - bei einer Seitenbetrachtung des Bestrahlungsmodules (6) oberhalb des Reflektors (18) und/oder der Kühlrippen (7) und/oder des Wärmetauschers befindlichen Mittenbereich (23) des Bestrahlungsmodules (6) eine Führung (24) für die vertikal nach oben in Richtung der Plattform (4) gerichtete Abführung des nach dem vollständigen oder teilweisen sowie einmaligen oder mehrmaligen Überstreichens des Leuchtmittels (17) erwärmten Bestrahlungsmodul-Kühlmediums (22), vorgesehen ist.

5. Vorrichtung (1) zur Bestrahlung eines Substrates (2) nach Anspruch 4, **dadurch gekennzeichnet**, das noch nicht erwärmte, frische Bestrahlungsmodul-Kühlmedium (21) zunächst den in Richtung der Rückseite (9) der Vorrichtung (1) und den in Richtung der Vorderseite (5) der Vorrichtung (1) gelegenen beiden Randbereichen der Glasscheibe (15) zuführbar ist, dann die Unterseite des Leuchtmittels (17) in Richtung der Mitte (23) des Bestrahlungsmodules (6) überstreicht, in dem Mittenbereich (23) das Leuchtmittel (17) in vertikal nach oben gerichteter Weise umströmt, dann - ausgehend von dem Mittenbereich (23) nach außen in Richtung der beiden Endbereiche (32) des Leuchtmittels (17) - die Oberseite des Leuchtmittels (17) und die Unterseite des Reflektors (18) überstreicht, dann die beiden Endbereiche (32) des Leuchtmittels (17) mit den elektrischen Kontakten des Leuchtmittels (17) überstreicht, dann in Richtung der Mitte (23) des Bestrahlungsmodules (6) - unter Kontakt mit auf der Rückseite des Reflektors (18) vorgesehenen Kühlrippen (7) oder statt diesen vorgesehenen Wärmetauschern - führbar ist und dann über eine mittige Führung (24) für die Abführung des erwärmten Bestrahlungsmodul-Kühlmediums (22) aus dem Bestrahlungsmodul (6) in Richtung der mittigen Führung (28) der Plattform (4) - für die Abführung des erwärmten Bestrahlungsmodul-Kühlmediums (22) nach außen - führbar ist.

6. Vorrichtung (1) zur Bestrahlung eines Substrates (2) nach einem der Ansprüche 1, oder 2, **dadurch gekennzeichnet, dass** in die Plattform (4) eine oder mehrere Leitungen (29) für die Führung des noch nicht erwärmten, frischen Bestrahlungsmodul-Kühlmediums (21) einmünden oder in die Plattform (4) integriert sind, wobei in diesen Leitungen (29) - außerhalb und/oder innerhalb der Plattform (4) - jeweils ein oder mehrere Gebläse (30) und/oder Pumpen vorgesehen sind, wobei diese Leitungen (29) in der Plattform (4) - bei einer Seitenbetrachtung - in Richtung der Mitte (23) der Plattform (4) verlaufen, wobei diese Leitungen (29) - mittelbar über eine mittige Führung (28) oder unmittelbar - in eine in dem Mittenbereich (23) der Plattform (4) befindliche Austrittsöffnung auf der Unterseite (8) der Plattform (4) münden, wobei auf der Oberseite (19) und in dem Mittenbereich (23) des Bestrahlungsmodules (6) eine oder mehrere - zu der Austrittsöffnung auf der Unterseite (8) der Plattform (4) korrespondierende und mit dieser zusammenwirkende - Eintrittsöffnungen für aus der Plattform (4) austretendes, noch nicht erwärmtes, frisches Bestrahlungsmodul-Kühlmedium (21) vorgesehen ist, wobei - stromabwärts von der mittigen Eintrittsöffnung in das Bestrahlungsmodul (6) - eine vertikale, nach unten (26) weisende Führung (24) für die Führung des noch nicht erwärmten, frischen Bestrahlungsmodul-Kühlmediums (21) aus der Austrittsöffnung auf der Unterseite (8) der Plattform (4), vorgesehen ist, wobei in dem unteren Endbereich dieser Führung eine Vorrichtung zur Aufspaltung des vertikal nach unten strömenden Bestrahlungsmodul-Kühlmedium-Stromes in einen in Richtung der Rückseite (9) und in einen in Richtung der Vorderseite (5) der Vorrichtung (1) gerichteten Bestrahlungsmodul-Kühlmedium-Teilstrom vorgesehen ist, wobei jeder dieser Bestrahlungsmodul-Kühlmedium-Teilströme - während seiner Strömung in Richtung des jeweiligen rückseitigen (9) oder vorderseitigen (5) offenen Endbereiches (32) - die mit der Rückseite des Reflektors (18) mittelbar oder unmittelbar in Verbindung stehenden Kühlrippen (7) oder Wärmetauscher durchströmt, danach den jeweiligen frontseitigen (5) oder rückseitigen (9) Endbereich (32) mit den elektrischen Kontakten für die Stromversorgung des Leuchtmittels (17) durchströmt, dann den oberhalb des Leuchtmittels (17) befindlichen Strahler-Bereich zwischen der Unterseite des Reflektors (18) und der Oberseite des Leuchtmittels (17) - ausgehend von dem vorderseitigen (5) oder rückseitigen (9) Endbereich (32) - in Richtung der Mitte (23) des Bestrahlungsmodules (6) durchströmt, dort das Leuchtmittel (17) in vertikal nach unten weisender Richtung und in Richtung der die Strahlungs-Austrittsöffnung (16) verschließenden Glasscheibe (15) umströmt, dann den unterhalb des Leuchtmittels (17) befindlichen Strahler-Bereich zwischen der Glasscheibe (15) und der Unterseite des Leuchtmittels (17) durchströmt, wobei stromabseitig hiervon eine oder mehrere vorderseitige (5) und/oder rückseitige (9) Führungen zur vertikalen, nach oben gerichteten Führung des erwärmten Bestrahlungsmodul-Kühlmedium-Teilstromes (22) in Richtung einer oder mehrerer, auf der Oberseite (19) des Bestrahlungsmodules (6) befindlicher Austrittsöffnungen vorgesehen sind, wobei auf der Unterseite (8) der Plattform (4) eine oder mehrere Eintrittsöffnungen für das - aus den auf der Oberseite (19) des Bestrahlungsmodules (6) befindlichen Austrittsöffnungen ausströmende - erwärmte Bestrahlungsmodul-Kühlmedium (22) vorgesehen sind, wobei diese Eintrittsöffnungen der Plattform (4) für erwärmtes Bestrahlungsmodul-Kühlmedium (22) mit Leitungen für die Führung von erwärmtem Bestrahlungsmodul-Kühlmedium (22) durch die Plattform (4) in einen außerhalb der Plattform (4) liegenden Bereich, in Verbindung stehen.

7. Vorrichtung (1) zur Bestrahlung eines Substrates (2) nach einem der Ansprüche 1 bis 6, **dadurch gekennzeichnet, dass** - bei einer Seitenbetrachtung der Plattform (4) - in dem Mittenbereich (23) der Plattform (4) eine - in Bezug auf die Plattform (4) nach außen verlaufende - Führung (28) für die Abführung des erwärmten Bestrahlungsmodul-Kühlmediums (22), welches aus der vertikal nach oben gerichteten mittigen (23) Führung (24) des Bestrahlungsmodules (6) für die Abführung von erwärmten Bestrahlungsmodul-Kühlmedium (22) stammt, vorgesehen ist, wobei die auf der Unterseite (8) der Plattform (4) liegende Eintrittsöffnung (33) der Plattform (4) für das erwärmte Bestrahlungsmodul-Kühlmedium (22) funktionell zusammenwirkend mit der auf der Oberseite (19) des Bestrahlungsmodules (6) befindlichen Öffnung (34) der Führung (24) für die Abführung des erwärmten Bestrahlungsmodul-Kühlmediums (22) aus dem Bestrahlungsmodul (6) angeordnet und ausgebildet ist.

8. Vorrichtung (1) zur Bestrahlung eines Substrates (2) nach einem der Ansprüche 1 bis 7, **dadurch gekennzeichnet, dass** sie eine oder mehrere einerseits zwischen der Vorderseite (5) jedes Modules (6, 36, 37) und andererseits zwischen der Vorderseite (5) der Plattform (4) wirkende Verriegelungseinrichtungen (38) umfasst, wobei nur in dieser verriegelnden Stellung der Verriegelungseinrichtung (38) eine elektrische Versorgung der Module (6, 36, 37) mittelbar oder unmittelbar über die Plattform (4) erfolgt.

9. Vorrichtung (1) zur Bestrahlung eines Substrates (2) nach einem der Ansprüche 1 bis 8, **dadurch gekennzeichnet, dass** sie eine oder mehrere elektrisch leitende Kupplungen (40) umfasst, welche zwischen der Unterseite (8) der Plattform (4) einerseits und der Oberseite (19) des Bestrahlungsmodules (6) andererseits - nur bei vollständigem Einschub des Bestrahlungsmodules (6) in seine jeweilige Modul-Anbringungs-Einrichtung (10) - elektrisch leitend wirken.

10. Vorrichtung (1) zur Bestrahlung eines Substrates (2) nach einem der Ansprüche 1 bis 9, **dadurch gekennzeichnet, dass** das eine oder die mehreren Leuchtmittel (17) für die Emission elektromagnetischer Strahlung jedes Bestrahlungsmodules (6) gleich oder voneinander verschieden sind, jeweils in Form einer oder mehrerer elektromagnetische Strahlung emittierender Dioden (LED) und/oder Halogen-Strahler und/oder Halogen-Röhren ausgebildet sind und jeweils in Form eines oder mehrerer Mikrowellen-Strahler (12 mm bis 1 mm) und/oder IR-Strahler (760 nm bis 0,5 mm; nahes Infrarot NIR: 760 nm bis 2,5 µm; mittleres Infrarot MIR: 2,5 µm bis 25 µm; fernes Infrarot FIR: 25 µm bis 500 µm) und/oder Strahler für sichtbares Licht (400 nm bis 750 nm) und/oder UV-Strahler (400 nm bis 10 nm) und/oder Röntgen-Strahler (100 nm bis 10⁻² pm) ausgebildet sind.

11. Vorrichtung (1) zur Bestrahlung eines Substrates (2) nach einem der Ansprüche 1 bis 10, **dadurch gekennzeichnet, dass** in dem Bereich der Rückseite (9) der Vorrichtung (1) zur Bestrahlung eines Substrates (2) eine vertikal ausgerichtete Befestigungsplatte (39) vorgesehen ist, an welcher die Rückseiten der Plattform (4) und/oder der Module (6, 36, 37) mittelbar über Modul-Anbringungs-Einrichtungen (10) oder unmittelbar anbringbar sind.

12. Vorrichtung (1) zur Bestrahlung eines Substrates (2) nach einem der Ansprüche 1 bis 11, **dadurch gekennzeichnet, dass** die unteren Enden (44, 45) der Schotten (41, 42) oder Trennwände jeweils eine Vorrichtung (47) zum Absperren oder Regeln von das zu bestrahlende Substrat (2) überstreichender Luft tragen, wobei diese Vorrichtungen (47) jeweils eine horizontale Länge aufweisen, die in dem Bereich von 0,5 mm bis 10,0 cm liegt, wobei der vertikale Abstand zwischen den Luft-Passage-Aussparungen (50) oder Öffnungen in den oberen Endbereichen (49) der Schotten (41, 42) oder Trennwände einerseits und den Vorrichtungen (47) zum Absperren und/oder Regeln von das zu bestrahlende Substrat (2) überstreichender Luft an den unteren Enden (44, 45) der Schotten (41, 42) oder Trennwände andererseits in dem Bereich von 1,0 cm bis 1,5 m liegt wobei der horizontale Abstand zwischen dem stromaufseitigen Schott (41) oder der stromaufseitgen Trennwand einerseits und der stromaufseitigen Außenwand des stromaufseitigen Substrat-Zuluft-Moduls (36) andererseits sowie zwischen dem stromabseitigen Schott (42) oder der stromabseitigen Trennwand einerseits und der stromabseitigen Außenwand des stromabseitigen Substrat-Abluft-Moduls (37) andererseits, jeweils in dem Bereich von 0,5 mm bis 20,0 cm liegt und wobei die horizontalen Abstände (51) zwischen den Schotten (41, 42) oder Trennwänden einerseits und dem oder den Druckköpfen (43) andererseits in dem Bereich von 0,5 mm bis 20,0 cm liegen.

## Claims

1. An apparatus (1) for irradiating a substrate (2), which comprises a platform (4) having a longitudinal axis (3), wherein the platform (4) is straight or curved in relation to its longitudinal axis (3), wherein one, two, three, four, five, six, seven, eight, nine, ten or more irradiation modules (6) and substrate supply air modules (36) and substrate exhaust air modules (37) are reversibly attachable directly or indirectly to a bottom side (8) of the platform (4) by sliding or inserting or mounting in one or more fixed or telescoping module attachment devices (10) provided on the bottom side (8) of the platform (4) - each extending from a front side (5) of the apparatus (1) and in the direction of a back side (9) of the apparatus (1), **characterized in that** this apparatus (1) - in relation to the conveying direction (48) of the substrate (2) to be irradiated - upstream of the most upstream, i.e. the farthest upstream placed, supply air module (36) for supplying substrate supply air (35) comprises one or more printheads (43), and downstream of the most downstream, i.e. the farthest downstream placed, exhaust air module (37) for extracting substrate supply air (35) comprises one or more printheads (43), wherein, between the upstream printhead(s) (43) and the most upstream supply air module (36) for supplying substrate supply air (35), a first bulkhead (41) or a first partition wall is provided and, between the downstream printhead(s) (43) and the most downstream exhaust air module (37) for extracting substrate supply air (35), a second bulkhead (42) or a second partition wall is provided, wherein, between the lower ends (44, 45) of the bulkheads (41, 42) or partition walls facing the substrate (2) to be irradiated on the one hand and the substrate (2) to be irradiated on the other hand, a gap (46) is formed, wherein the vertical height of this gap (46) lies in the range of 0.1 mm to 5.0 mm, wherein, in the upper end regions (49) of the two bulkheads (41, 42) or partition walls facing away from the substrate (2) to be irradiated, one or more small-area or large-area recesses (50) or openings are provided for the passage of air.

2. The apparatus (1) for irradiating a substrate (2) according to claim 1, **characterized in that** the one or more module attachment devices (10) each comprise a wall (12) aligned perpendicular to the bottom side (8) of the platform (4), which walls, in their downwardly facing region, each bear a bilaterally extending, ridge-like projection (13) and/or a linear recess for bearing modules (6, 36, 37) that can be slid back and forth and slid therein, wherein each module (6, 36, 37) comprises one or more bar-like and/or the linear recesses (11) or projections configured so as to correspond to the projection-like or recess-shaped bearing element of the wall (12).

3. The apparatus (1) for irradiating a substrate (2) according to any one of claims 1 or 2, **characterized in that** - in relation to the supply of not yet heated, fresh, gaseous, or liquid irradiation module cooling medium (21) via one or more conduits (29) for guiding the not yet heated, fresh irradiation module cooling medium (21) to the platform (4) - one or more separate ventilators (30) for the not yet heated, fresh irradiation module cooling medium (21) are provided upstream of the platform (4), or wherein, in each platform (4), one or more conduits (29) for guiding the not yet heated, fresh irradiation module cooling medium (21) open from the outside, wherein, one or more ventilators (30) can be integrated into the one or more conduits (29) for guiding the not yet heated, fresh irradiation module cooling medium (21) - then inside or outside the platform (4) - which ventilators accelerate and/or compress the not yet heated, fresh irradiation module cooling medium (21) in the direction of one or more outlet openings (31) of the platform (4) for not yet heated and fresh irradiation module cooling medium (21), wherein the one or more outlet openings (31) of the platform (4) for not yet heated, fresh irradiation module cooling medium (21) are provided on the bottom side (8) of the platform (4) and at least in the region of the back side (9) of the apparatus (1) and/or in the region of the front side (5) of the apparatus (1).

4. The apparatus (1) for irradiating a substrate (2) according to any one of claims 1, 2, or 3, **characterized in that**, on the top side (19) of each irradiation module (6), one or more irradiation module cooling medium inlet openings (20) are provided for supplying the not yet heated, fresh irradiation module cooling medium (21) from the platform (4), wherein these irradiation module cooling medium inlet openings (20) of each irradiation module (6) are functionally arranged and configured so as to operate in tandem with the outlet openings (31) of the platform (4) for not yet heated and fresh irradiation module cooling medium (21), wherein the irradiation module cooling medium inlet openings (20) are connected to the end regions (32) of the lamp (17) located in the region of the front side (5) and/or the back side (9) of the apparatus (1) in a manner so as to guide not yet heated and fresh cooling medium (21), wherein, just below (26) the lamp (17) - for the purpose of a gas-tight closure of the radiation outlet opening (16) of the irradiation module (6) as well as for the purpose of guiding the irradiation module cooling medium (21) in a closed circuit within the irradiation module (6) -, a fully or partially transparent pane (15) for the radiation emitted by the lamp (17) and, just above the lamp (17), a reflector (18) - with or without cooling fins (7) or a heat exchanger - are provided, wherein not yet heated, fresh irradiation module cooling medium (21) can be supplied to the respective open end region (32) of the gap between the lower (26) glass pane (15) and the reflector (18), said end region being located in the direction of the back side (9) of the apparatus (1) and/or in the direction of the front side (5) of the apparatus (1), wherein, in the center region (23) of the irradiation module (6), said center region being located - when viewed from the side of the irradiation module (6) - above the reflector (18) and/or the cooling fins (7) and/or the heat exchanger, a guide (24) is provided for the discharge of the irradiation module cooling medium (22) heated after the full or partial as well as one-time or repeated overcoating of the lamp (17), said discharge being directed vertically upward in the direction of the platform (4).

5. The apparatus (1) for irradiating a substrate (2) according to claim 4, **characterized in that** not yet heated, fresh irradiation module cooling medium (21) is initially suppliable in the direction of the back side (9) of the apparatus (1) and the two edge regions of the glass pane (15) located in the direction of the front side (5) of the apparatus (1), then overcoats the bottom of the lamp (17) in the direction of the center (23) of the irradiation module (6), flows around the lamp (17) in the center region (23) in a vertically upwardly directed manner, then - starting from the center region (23) and proceeding outwardly in the direction of the two end regions (32) of the lamp (17) - overcoats the top side of the lamp (17) and the bottom side of the reflector (18), then overcoats the two end regions (32) of the lamp (17) with the electrical contacts of the lamp (17), then is guidable in the direction of the center (23) of the irradiation module (6) - while contacting cooling fins (7) or, instead of the latter, heat exchangers provided on the back side of the reflector (18) - and then is guidable via a central guide (24) for the discharge of the heated irradiation module cooling medium (22) from the irradiation module (6) in the direction of the central guide (28) of the platform (4) - for the discharge of the heated irradiation module cooling medium (22) to the outside.

6. The apparatus (1) for irradiating a substrate (2) according to any one of claims 1 or 2, **characterized in that** one or more conduits (29) for guiding the not yet heated, fresh irradiation module cooling medium (21) open into the platform (4) or are integrated into the platform (4), wherein, in these conduits (29) - outside and/or inside the platform (4) - one or more ventilators (30) and/or pumps are respectively provided, wherein these conduits (29) extend in the platform (4) - when viewed from the side - in the direction of the center (23) of the platform (4), wherein these conduits (29) - indirectly via a central guide (28) or directly - open into an outlet opening located in the center region (23) of the platform (4) on the bottom side (8) of the platform (4), wherein, on the top side (19) and in the center region (23) of the irradiation module (6), one or more inlet openings - corresponding to the outlet opening on the bottom side (8) of the platform (4) and cooperating therewith - are provided for not yet heated, fresh irradiation module cooling medium (21) exiting from the platform (4), wherein - downstream of the central inlet opening into the irradiation module (6) - a vertical, downwardly (26) facing guide (24) is provided for guiding the not yet heated, fresh irradiation module cooling medium (21) from the outlet opening on the bottom side (8) of the platform (4), wherein, in the lower end region of this guide, an apparatus is provided for splitting the vertically downwardly flowing irradiation module cooling medium flow into an irradiation module cooling medium partial flow directed in the direction of the back side (9) and into an irradiation module cooling medium partial flow directed in the direction of the front side (5) of the apparatus (1), wherein each of these irradiation module cooling medium partial flows - while flowing in the direction of the respective end region (32) open to the back side (9) or front side (5) - through the cooling fins (7) or heat exchanger indirectly or directly connected to the back side of the reflector (18), then flows through the respective front-side (5) or back-side (9) end region (32) with the electrical contacts for the power supply of the lamp (17), then flows through the emitter region located above the lamp (17) between the bottom of the reflector (18) and the top of the lamp (17) - proceeding from the front-side (5) or back-side (9) end region (32) - in the direction of the center (23) of the irradiation module (6), then flows around the lamp (17) in a vertical, downwardly facing direction and in the direction of the glass pane (15) closing the radiation outlet opening (16), then flows through the emitter region located below the lamp (17) between the glass pane (15) and the bottom of the lamp (17), wherein, downstream thereof, one or more front-side (5) and/or back-side (9) guides are provided for the vertical, upwardly directed guiding of the heated irradiation module cooling medium partial flow (22) in the direction of one or more outlet openings located on the top side (19) of the irradiation module (6), wherein one or more inlet openings are provided on the bottom side (8) of the platform (4) for the heated irradiation module cooling medium (22) - flowing out of the outlet openings located on the upper side (19) of the irradiation module (6) -, wherein said inlet openings of the platform (4) for heated irradiation module cooling medium (22) are connected to conduits for guiding heated irradiation module cooling medium (22) through the platform (4) into a region located outside the platform (4).

7. The apparatus (1) for irradiating a substrate (2) according to any one of claims 1 to 6, **characterized in that** - when the platform (4) is viewed from the side - a guide (28) - extending outwardly in relation to the platform (4) - is provided in the center region (23) of the platform (4) for discharging the heated irradiation module cooling medium (22) originating from the vertical, upwardly directed central (23) guide (24) of the irradiation module (6) for discharging heated irradiation module cooling medium (22), wherein the inlet opening (33) of the platform (4) for the heated irradiation module cooling medium (22) located on the bottom side (8) of the platform (4) is functionally arranged and configured so as to operate in tandem with the opening (34) of the guide (24) located on the top side (19) of the irradiation module (6) for the discharge of the heated irradiation module cooling medium (22) from the irradiation module (6).

8. The apparatus (1) for irradiating a substrate (2) according to any one of claims 1 to 7, **characterized in that** it comprises one or more locking devices (38) acting on the one hand between the front side (5) of each module (6, 36, 37) and on the other hand between the front side (5) of the platform (4), wherein an electrical supply of the modules (6, 36, 37) occurs indirectly or directly via the platform (4) only in this locking position of the locking device (38).

9. The apparatus (1) for irradiating a substrate (2) according to any one of claims 1 to 8, **characterized in that** it comprises one or more electrically conductive couplings (40), which act in an electrically conductive manner between the bottom side (8) of the platform (4) on the one hand and the top side (19) of the irradiation module (6) on the other hand - only when the irradiation module (6) is fully inserted into its respective module attachment device (10).

10. The apparatus (1) for irradiating a substrate (2) according to any one of claims 1 to 9, **characterized in that** the one or more lamps (17) for the emission of electromagnetic radiation of each irradiation module (6) are the same or different from one another, are respectively configured in the form of one or more electromagnetic radiation-emitting diodes (LEDs) and/or halogen emitters and/or halogen tubes, and are respectively configured in the form of one or more microwave emitters (12 mm to 1 mm) and/or IR emitters (760 nm to 0.5 mm; near infrared NIR: 760 nm to 2.5 µm; mean infrared MIR: 2.5 µm to 25 µm; far infrared FIR: 25 µm to 500 µm) and/or emitters for visible light (400 nm to 750 nm) and/or UV emitters (400 nm to 10 nm) and/or X-ray emitters (100 nm to 10⁻²pm).

11. The apparatus (1) for irradiating a substrate (2) according to any one of claims 1 to 10, **characterized in that**, in the region of the back side (9) of the apparatus (1) for irradiating a substrate (2), a vertically aligned fastening plate (39) is provided, at which the back sides of the platform (4) and/or the modules (6, 36, 37) are attachable indirectly via module attachment devices (10) or directly.

12. The apparatus (1) for irradiating a substrate (2) according to any one of claims 1 to 11, **characterized in that** the lower ends (44, 45) of the bulkheads (41, 42) or partition walls each bear an apparatus (47) for shutting off or controlling air overcoating the substrate (2) to be irradiated, wherein these apparatuses (47) each have a horizontal length in the range of 0.5 mm to 10.0 cm, wherein the vertical distance between the air passage recesses (50) or openings in the upper end regions (49) of the bulkheads (41, 42) or partition walls on the one hand and the apparatuses (47) for shutting off and/or controlling air overcoating the substrate (2) to be irradiated at the lower ends (44, 45) of the bulkheads (41, 42) or partition walls on the other hand lies in the range of 1.0 cm to 1.5 m, wherein the horizontal distance between the upstream bulkhead (41) or the upstream partition wall on the one hand and the upstream outer wall of the upstream substrate supply air module (36) on the other hand, as well as between the downstream bulkhead (42) or the downstream partition wall on the one hand and the downstream outer wall of the downstream substrate exhaust air module (37) on the other hand, respectively lies in the range of 0.5 mm to 20.0 cm, and wherein the horizontal distances (51) between the bulkheads (41, 42) or partition walls on the one hand and the printhead(s) (43) on the other hand lies in the range of 0.5 mm to 20.0 cm.

## Revendications

1. Dispositif (1), destiné à irradier un substrat (2), lequel comprend une plateforme (4) dotée d'un axe longitudinal (3), la plateforme (4) étant rectiligne ou curviligne en rapport à son axe longitudinal (3), un, deux, trois quatre, cinq, six, sept, huit, neuf, dix modules d'irradiation (6) et modules d'apport d'air (36) pour le substrat et modules d'évacuation d'air (37) pour le substrat ou plus étant susceptibles d"être montés de manière réversible, indirectement ou directement sur une face inférieure (8) de la plateforme (4) par insertion, emboîtement ou accrochage dans un ou plusieurs systèmes de montage (10) de modules, stationnaires ou télescopiques, prévus sur la face inférieure (8) de la plateforme (4), partant chacun de la face antérieure (5) du dispositif (1) et s'écoulant dans la direction d'une face postérieure (9) du dispositif (1),
**caractérisé en ce que** ledit dispositif (1) comprend (en rapport à la direction de transport (48) du substrat (2) qu'il s'agit d'irradier) en amont du module d'apport d'air (36) pour le substrat en amont extrême, c'est-à-dire situé le plus en amont, pour l'alimentation d'air frais (35) pour le substrat, un ou plusieurs boutons poussoirs (43) et en aval du module d'évacuation d'air (37) pour le substrat en aval extrême, c'est-à-dire situé le plus en aval, pour l'aspiration d'air frais (35) pour le substrat un ou plusieurs boutons poussoirs (43, entre le ou les boutons poussoirs (43) placés en amont et le module d'apport d'air (36) pour le substrat en amont extrême étant prévue pour l'alimentation d'air frais (35) pour le substrat une première cloison (41) ou une première paroi de séparation et entre le ou les boutons poussoirs (43) placés en aval et le module d'évacuation d'air (37) pour le substrat en aval extrême étant prévue pour l'évacuation d'air frais (35) pour le substrat une deuxième cloison (42) ou une deuxième paroi de séparation, entre les extrémités (44, 45) inférieures, dirigées vers le substrat (2) qu'il s'agit d'irradier des cloisons (41, 42) ou parois de séparation d'une part et le substrat (2) qu'il s'agit d'irradier d'autre part étant conçue une fente (46), la hauteur verticale de ladite fente (46) se situant dans l'ordre de 0,1 mm à 5,0 mm, dans les zones d'extrémité (49) supérieures, dirigées vers le substrat (2) qu'il s'agit d'irradier des deux cloisons (41, 42) ou parois de séparation étant prévues chaque fois une ou plusieurs encoches (50) ou ouvertures de petite ou de grande surface pour le passage d'air.

2. Dispositif (1) destiné à irradier un substrat (2) selon la revendication 1, **caractérisé en ce que** l'un ou les plusieurs systèmes de montage (10) de modules comprennent chacun une paroi (12) orientée à angle droit par rapport à la face inférieure (8) de la plateforme (4), qui dans sa zone tournée vers le bas porte chaque fois une saillie (13) en forme de bourrelet, s'étendant de part et d'autre et / ou une encoche en forme de ligne, destinée à porter des modules (6, 36, 37) déplaçables en va-et-vient et insérables dans celle-ci, chaque module (6, 36, 37) comportant chaque fois une ou plusieurs encoches (11) ou saillies en forme de barrettes et / ou de lignes, conçues en correspondance avec l'élément porteur en forme de saille ou d'encoche de la paroi (12).

3. Dispositif (1) destiné à irradier un substrat (2) selon l'une quelconque des revendications 1 ou 2, **caractérisé en ce que** (en rapport à l'apport d'agent de refroidissement (21) gazeux ou liquide, frais, non encore échauffé du module d'irradiation via une ou plusieurs ou conduites (29), pour le guidage de l'agent de refroidissement (21) frais, non encore échauffé du module d'irradiation vers la plateforme (4), sont prévus en amont de la plateforme (4) un ou plusieurs ventilateurs (30) séparés pour l'agent de refroidissement (21) frais, non encore échauffé du module d'irradiation ou dans chaque plateforme (4) débouchant une ou plusieurs ou conduites (29) pour le guidage à partir de l'extérieur de l'agent de refroidissement (21) frais, non encore échauffé du module d'irradiation, dans l'une ou dans les plusieurs conduites (29), pour le guidage de l'agent de refroidissement (21) frais, non encore échauffé du module d'irradiation (alors à l'intérieur ou à l'extérieur de la plateforme (4) étant intégrables chaque fois un ou plusieurs ventilateurs (30), lesquels accélèrent et / ou compriment l'agent de refroidissement (21) frais, non encore échauffé du module d'irradiation en direction d'une ou de plusieurs ouvertures de sortie (31) de la plateforme (4) pour de l'agent de refroidissement (21) frais et non encore échauffé du module d'irradiation, l'une ou les plusieurs ouvertures de sortie (31) de la plateforme (4) pour de l'agent de refroidissement (21) frais, non encore échauffé du module d'irradiation étant prévues sur la face inférieure (8) de la plateforme (4) et au moins dans la zone de la face postérieure (9) du dispositif (1) et / ou dans la zone de la face antérieure (5) du dispositif (1).

4. Dispositif (1) destiné à irradier un substrat (2) selon l'une quelconque des revendications 1, 2 ou 3, **caractérisé en ce que** sur la face supérieure (19) de chaque module d'irradiation (6) sont prévues une ou plusieurs ouvertures d'entrée (20) d'agent de refroidissement du module d'irradiation pour l'apport de l'agent de refroidissement (21) frais, non encore échauffé du module d'irradiation à partir de la plateforme (4), lesdites ouvertures d'entrée (20) d'agent de refroidissement du module d'irradiation de chaque module d'irradiation (6) étant placées et conçues pour être susceptibles d'être en interaction fonctionnelle avec les ouvertures de sortie (31) de la plateforme (4) pour de l'agent de refroidissement (21) frais, non encore échauffé du module d'irradiation, les ouvertures d'entrée (20) d'agent de refroidissement du module d'irradiation étant en liaison (en conduisant de l'agent de refroidissement (21) frais et non encore échauffé) avec les zones d'extrémité (32) du moyen d'éclairage (17) situées dans la zone de la face antérieure (5) et / ou de la face postérieure (9) du dispositif (1), juste au-dessous (26) du moyen d'éclairage (17) (aux fins d'assurer une fermeture étanche au gaz de l'ouverture de sortie (16) du rayonnement du module d'irradiation (6), ainsi qu'aux fins de guider l'agent de refroidissement (21) du module d'irradiation dans un circuit fermé à l'intérieur du module d'irradiation (6) étant prévue une vitre (15) totalement ou partiellement transparente au rayonnement émis par le moyen d'éclairage (17) et juste au-dessus du moyen d'éclairage (17) étant prévu un réflecteur (18) (pourvu ou non de nervures de refroidissement (7) ou d'échangeurs thermiques), l'agent de refroidissement (21) frais, non encore échauffé du module d'irradiation étant susceptible d'être amené vers la zone d'extrémité (32) de la fente chaque fois ouverte, située dans la direction de la face postérieure (9) du dispositif (1) et / ou celle située en direction de la face antérieure (5) du dispositif (1), entre la vitre en verre (15) inférieure (26) et le réflecteur (18), dans la zone centrale (23) du module d'irradiation (6) située au-dessus du réflecteur (18) et / ou des nervures de refroidissement (7) et / ou de l'échangeur thermique (lors d'une observation latérale du module d'irradiation (6) étant prévu un guidage (24) pour l'évacuation orientée à la verticale vers le haut en direction de la plateforme (4) de l'agent de refroidissement (22) du module d'irradiation échauffé après avoir balayé totalement ou partiellement ainsi qu'une fois ou plusieurs fois le moyen d'éclairage (17).

5. Dispositif (1) destiné à irradier un substrat (2) selon la revendication 4, **caractérisé en ce que** l'agent de refroidissement (21) frais, non encore échauffé du module d'irradiation est susceptible d'être amené d'abord vers les deux zones marginales de la vitre en verre (15) situées dans la direction de la face postérieure (9) du dispositif (1) et celles situées sur la face antérieure (5) du dispositif (1), balaye ensuite la face inférieure du moyen d'éclairage (17) en direction du centre (23) du module d'irradiation (6), circule dans la zone centrale (23) autour du moyen d'éclairage (17) de façon dirigée vers le haut à la verticale, puis (en partant de la zone centrale (23) vers l'extérieur, en direction de deux zones d'extrémité (32) du moyen d'éclairage (17), balaye la face supérieure du moyen d'éclairage (17) et la face inférieure du réflecteur (18), balaye ensuite les deux zones d'extrémité (32) du moyen d'éclairage (17) avec les contacts électriques du moyen d'éclairage (17), puis peut être guidé dans la direction du centre (23) du module d'irradiation (6) (en entrant en contact avec des nervures de refroidissement (7) ou des échangeurs thermiques prévus en remplacement de celles-ci sur la face postérieure du réflecteur (18) et peut être guidé ensuite via un guidage (24) central, pour l'évacuation de l'agent de refroidissement (22) échauffé du module d'irradiation hors du module d'irradiation (6) en direction du guidage (28) central de la plateforme (4) (pour l'évacuation vers l'extérieur de l'agent de refroidissement (22) échauffé du module d'irradiation).

6. Dispositif (1) destiné à irradier un substrat (2) selon l'une quelconque des revendications 1, ou 2, **caractérisé en ce que** une ou plusieurs conduites (29) pour le guidage de l'agent de refroidissement (21) frais, non encore échauffé du module d'irradiation débouchent dans la plateforme (4) ou sont intégrées dans la plateforme (4), dans lesdites conduites (29) (à l'extérieur et / ou à l'intérieur de la plateforme (4) étant-prévu(e)s chaque fois un ou plusieurs ventilateurs (30) et / ou pompes, lesdites conduites (29) s'écoulant (lors d'une observation latérale) dans la plateforme (4) en direction du centre (23) de la plateforme (4), lesdites conduites (29) débouchant (indirectement, via un guidage (28) central ou directement) dans une ouverture de sortie située dans la zone centrale (23) de la plateforme (4) sur la face inférieure (8) de la plateforme (4), sur la face supérieure (19) et dans la zone centrale (23) du module d'irradiation (6) étant prévues une ou plusieurs ouvertures d'entrée (correspondant à l'ouverture de sortie sur la face inférieure (8) de la plateforme (4) et interagissant avec celle-ci) pour de l'agent de refroidissement (21) frais, non encore échauffé du module d'irradiation sortant de la plateforme (4), un guidage (24) vertical, tourné vers le bas (26) étant prévu (en aval de l'ouverture d'entrée centrale dans le module d'irradiation (6) pour le guidage de l'agent de refroidissement (21) frais, non encore échauffé du module d'irradiation hors de l'ouverture de sortie sur la face inférieure (8) de la plateforme (4), dans la zone d'extrémité inférieure dudit guidage étant prévu un dispositif destiné à diviser le flux d'agent de refroidissement du module d'irradiation s'écoulant vers le bas en un flux partiel d'agent de refroidissement du module d'irradiation orienté en direction de la face postérieure (9) et un autre orienté en direction de la face antérieure (5) du dispositif (1), chacun desdits flux partiels d'agent de refroidissement du module d'irradiation circulant (pendant son écoulement dans la direction de la zone d'extrémité (32) ouverte respectivement sur la face arrière (9) ou sur la face avant (5) à travers les nervures de refroidissement (7) ou échangeurs thermiques qui sont en liaison indirecte ou directe avec la face postérieure du réflecteur (18), circulant ensuite à travers la zone d'extrémité (32) respectivement frontale (5) ou arrière (9) avec les contacts électriques pour l'alimentation électrique du moyen d'éclairage (17), puis circulant à travers la zone des émetteurs située au-dessus du moyen d'éclairage (17), entre la face inférieure du réflecteur (18) et la face supérieure du moyen d'éclairage (17) (en partant de la zone d'extrémité (32) avant (5) ou arrière (9) en direction du centre (23) du module d'irradiation (6), y circulant autour du moyen d'éclairage (17) en direction verticale, orientée vers le bas et en direction de la vitre en verre (15) qui ferme l'ouverture de sortie (16) du rayonnement, puis circulant à travers la zone des émetteurs située en-dessous du moyen d'éclairage (17), entre la vitre en verre (15) et la face inférieure du moyen d'éclairage (17), en aval d'où sont prévus un ou plusieurs guidages avant (5) et / ou arrière (9), pour le guidage vertical, orienté vers le haut du flux partiel (22) de l'agent de refroidissement échauffé du modulé d'irradiation dans la direction d'une ou de plusieurs ouvertures de sortie situées sur la face supérieure (19) du module d'irradiation (6), sur la face inférieure (8) de la plateforme (4) étant prévues une ou plusieurs ouvertures d'entrée pour l'agent de refroidissement (22) échauffé du module d'irradiation (s'écoulant hors des ouvertures de sortie situées sur la face supérieure (19) du module d'irradiation (6), lesdites ouvertures d'entrée de la plateforme (4) pour de l'agent de refroidissement (22) échauffé du module d'irradiation étant en liaison avec des conduites pour le guidage d'agent de refroidissement (22) échauffé du module d'irradiation à travers la plateforme (4) dans une zone située à l'extérieur de la plateforme (4).

7. Dispositif (1) destiné à irradier un substrat (2) selon l'une quelconque des revendications 1 à 6, **caractérisé en ce que** dans la zone centrale (23) de la plateforme (4) (lors d'une observation latérale de la plateforme (4) est prévu un guidage (28) (s'écoulant vers l'extérieur en rapport à la plateforme (4) pour l'évacuation de l'agent de refroidissement (22) échauffé du module d'irradiation, lequel émane du guidage (24) central (23) du module d'irradiation (6) orienté à la verticale vers le haut, pour l'évacuation d'agent de refroidissement (22) échauffé du module d'irradiation, l'ouverture d'entrée (33) de la plateforme (4) située sur la face inférieure (8) de la plateforme (4) pour l'agent de refroidissement (22) échauffé du module d'irradiation étant placée et conçue pour interagir fonctionnellement avec l'ouverture (34) du guidage (24) située sur la face supérieure (19) du module d'irradiation (6), pour l'évacuation de l'agent de refroidissement (22) échauffé du module d'irradiation hors du module d'irradiation (6).

8. Dispositif (1) destiné à irradier un substrat (2) selon l'une quelconque des revendications 1 à 7, **caractérisé en ce qu'**il comprend un ou plusieurs systèmes de verrouillage (38) agissant d'une part entre la face antérieure (5) de chaque module (6, 36, 37) et d'autre part entre la face antérieure (5) de la plateforme (4), seulement dans cette position verrouillée du système de verrouillage (38), une alimentation électrique des modules (6, 36, 37) ayant lieu indirectement ou directement via la plateforme (4).

9. Dispositif (1) destiné à irradier un substrat (2) selon l'une quelconque des revendications 1 à 8, **caractérisé en ce qu'**il comprend un ou plusieurs accouplements (40) conducteurs d'électricité, lesquels agissent de manière à conduire l'électricité entre la face inférieure (8) de la plateforme (4) d'une part et la face supérieure (19) du module d'irradiation (6) d'autre part (uniquement lorsque le module d'irradiation (6) est totalement inséré dans son système de montage (10) de modules respectif).

10. Dispositif (1) destiné à irradier un substrat (2) selon l'une quelconque des revendications 1 à 9, **caractérisé en ce que** l'un ou les plusieurs moyens d'éclairage (17) pour l'émission d'un rayonnement électromagnétique de chaque module d'irradiation (6) sont identiques ou différents les uns des autres, sont conçus chacun sous la forme d'une ou de plusieurs diodes (LED) et / ou émetteurs halogènes et / ou tubes halogènes émettant un ou plusieurs rayonnements électromagnétiques et sont conçus chacun sous la forme d'un ou de plusieurs émetteurs de micro-ondes (12 mm à 1 mm) et / ou émetteurs d'IR (760 nm à 0,5 mm ; proche infrarouge NIR : 760 nm à 2,5 µm ; infrarouge intermédiaire MIR : 2,5 µm à 25 µm ; infrarouge lointain FIR : 25 µm à 500 µm) et / ou émetteurs de lumière visible (400 nm à 750 nm) et / ou émetteurs UV (400 nm à 10 nm) et / ou émetteurs de rayons X (100 nm à 10⁻² pm).

11. Dispositif (1) destiné à irradier un substrat (2) selon l'une quelconque des revendications 1 à 10, **caractérisé en ce que** dans la zone de la face postérieure (9) du dispositif (1) destiné à irradier un substrat (2) est prévue une plaque de fixation (39) orientée à la verticale, sur laquelle les faces postérieures de la plateforme (4) et / ou des modules (6, 36, 37) sont susceptibles d'être montées indirectement via des systèmes de montage (10) de modules ou directement

12. Dispositif (1) destiné à irradier un substrat (2) selon l'une quelconque des revendications 1 à 11, **caractérisé en ce que** les extrémités (44, 45) inférieures des cloisons (41, 42) ou parois de séparation portent chacune un dispositif (47) destiné à bloquer ou à réguler l'air qui balaye le substrat (2) qu'il s'agit d'irradier, lesdits dispositifs (47) comportant chacun une longueur horizontale qui se situe dans l'ordre de 0,5 mm à 10,0 cm, l'écart vertical entre les encoches (50) de passage d'air ou ouvertures dans les zones d'extrémité (49) supérieures des cloisons (41, 42) ou parois de séparation d'une part et les dispositifs (47) destinés à bloquer et / ou réguler de l'air qui balaye le substrat (2) qu'il s'agit d'irradier sur les extrémités inférieures (44, 45) des cloisons (41, 42) ou parois de séparation d'autre part se situant dans l'ordre de 1,0 cm à 1,5 m, l'écart horizontal entre la cloison (41) située en amont ou la paroi de séparation située en amont d'une part et la paroi extérieure située en amont du module d'apport d'air (36) pour le substrat d'autre part, ainsi qu'entre la cloison (42) située en aval ou la paroi de séparation située en aval d'une part et la paroi située en aval du module d'évacuation d'air (37) pour le substrat d'autre part se situant respectivement dans l'ordre de 0,5 mm à 20,0 cm et les écarts horizontaux (51) entre les cloisons (41, 42) ou parois de séparation d'une part et le ou les boutons poussoirs (43) d'autre part se situant dans l'ordre de 0,5 mm à 20,0 cm.
